# EUROPÄISCHE PATENTSCHRIFT

(11) **EP 3 207 610 B1**
(45) Veröffentlichungstag und Bekanntmachung des Hinweises auf die Patenterteilung: **11.08.2021**
(21) Anmeldenummer: 14815647.4
(22) Anmeldetag: 12.12.2014
(51) Int. Cl.: H02H 7/26, H02H 3/40, G01R 31/08, G01R 27/08

(54) **VERFAHREN UND SCHUTZEINRICHTUNG ZUM ERZEUGEN EINES EINE FEHLERART EINES FEHLERS IN EINEM MEHRPHASIGEN ELEKTRISCHEN ENERGIEVERSORGUNGSNETZ ANGEBENDEN FEHLERSIGNALS**
METHOD AND PROTECTION DEVICE FOR GENERATING AN ERROR SIGNAL INDICATING AN ERROR TYPE OF AN ERROR IN A MULTI-PHASE ELECTRICAL ENERGY SUPPLY NETWORK
PROCÉDÉ ET DISPOSITIF DE PROTECTION POUR GÉNÉRER UN SIGNAL DE DÉFAUT INDIQUANT UN TYPE DE DÉFAUT D'UN RÉSEAU D'ALIMENTATION EN ÉNERGIE ÉLECTRIQUE POLYPHASÉE

(43) Veröffentlichungstag der Anmeldung: 23.08.2017
(73) Patentinhaber: Siemens Aktiengesellschaft, 80333 München (DE)
(72) Erfinder: BLUMSCHEIN, Jörg, 14165 Berlin (DE); DZIENIS, Cezary, 14624 Dallgow-Döberitz (DE); LINDEL, Tomasz Dawid, 12349 Berlin (DE); YELGIN, Yilmaz, 13589 Berlin (DE)
(86) Internationale Anmeldenummer: PCT/EP2014/077629
(87) Internationale Veröffentlichungsnummer: WO 2016/091334

(56) Entgegenhaltungen:
- EP-A1- 2 113 778
- EP-A2- 1 207 610
- WO-A1-2008/034936
- RU-C1- 2 447 454
- None

## Beschreibung

Die Erfindung betrifft ein Verfahren zum Erzeugen eines eine Fehlerart eines Fehlers in einem mehrphasigen elektrischen Energieversorgungsnetz angebenden Fehlersignals, bei dem an mindestens einer Messstelle in dem Energieversorgungsnetz Messwerte erfasst werden, die einen aktuellen Betriebszustand des Energieversorgungsnetzes beschreiben, die Messwerte an eine Schutzeinrichtung übermittelt werden, mittels einer Auswerteinrichtung der Schutzeinrichtung unter Verwendung der Messwerte jede mögliche Schleife des Energieversorgungsnetzes, die von einem Fehler betroffen sein kann, hinsichtlich der Erkennung der Fehlerart eines Fehlers ausgewertet wird, und bei Vorliegen eines Fehlers das Fehlersignal erzeugt wird, wobei für jede mögliche Schleife die Messwerte und/oder aus den Messwerten abgeleitete Werte unter Verwendung von zumindest zwei unterschiedlichen Schutzkriterien ausgewertet werden, wobei jedes der Schutzkriterien dazu geeignet ist, auf eine Fehlerart eines vorliegenden Fehlers in der jeweils ausgewerteten Schleife hinzuweisen; und das Fehlersignal unter Berücksichtigung aller vorliegenden Ergebnisse der Auswertung der Schutzkriterien erzeugt wird. Die Erfindung bezieht sich auch auf eine Schutzeinrichtung zum Erzeugen eines eine Fehlerart eines Fehlers in einem mehrphasigen elektrischen Energieversorgungsnetz angebenden Fehlersignals mit einer Auswerteinrichtung zur Durchführung eines solchen Verfahrens.

Ein solches Verfahren ist z. B. aus der EP 1 207 610 A2 bekannt. Ein Verfahren zur Fehlerdistanzbestimmung ist zudem aus der EP 2 113 778 A2 bekannt. Außerdem zeigt die WO 2008/034936 A1 ein Verfahren, bei dem einerseits eine Fehlerschleife erkannt und andererseits eine Fehlerrichtung ermittelt wird.

Zur Überwachung von Primärkomponenten, z.B. Leitungen, elektrischer Energieversorgungsnetze werden sogenannte Schutzeinrichtungen eingesetzt, um unzulässige Betriebszustände der jeweils überwachten Primärkomponente, die beispielsweise durch Kurzschlüsse oder Erdkurzschlüsse hervorgerufen sein können, zu erkennen und automatisch abzuschalten. Hierzu nimmt die Schutzeinrichtung üblicherweise an einer oder mehreren Messstellen in dem Energieversorgungsnetz Messwerte auf, beispielsweise Strom- und/oder Spannungsmesswerte, die den Betriebszustand der Primärkomponente charakterisieren. Zur Ausführung seiner Schutzfunktion, wertet die Schutzeinrichtung daraufhin die Messwerte unter Ausführung eines sogenannten Schutzalgorithmus, also einer Berechnungs- und/oder logischen Verknüpfungsvorschrift zur Auswertung der aufgenommenen Messwerte, aus und erzeugt in Abhängigkeit vom Ergebnis der Auswertung gegebenenfalls ein Auslösesignal, das einen mit der Schutzeinrichtung in Verbindung stehenden Leistungsschalter zum Öffnen seiner Schaltkontakte veranlasst, um die fehlerbehaftete Leitung vom übrigen Energieversorgungsnetz abzutrennen.

Ein Beispiel eines häufig zur Überwachung von Leitungen elektrischer Energieversorgungsnetze eingesetzten Schutzalgorithmus arbeitet nach dem sogenannten Distanzschutzverfahren, bei dem aus Strom- und Spannungsmesswerten in einer komplexen Zahlenebene liegende Impedanzwerte berechnet werden und überprüft wird, ob die Impedanzwerte innerhalb eines - auch als Auslösepolygon bezeichneten - vorgegebenen Auslösebereiches liegen. Sofern die Impedanzwerte innerhalb dieses vorgegebenen Auslösebereiches liegen, stellt die Schutzeinrichtung einen unzulässigen Betriebszustand an der von ihr überwachten Leitung des elektrischen Energieversorgungsnetzes fest und sendet ein Auslösesignal an einen oder mehrere die Leitung begrenzende Leistungsschalter, um die fehlerhafte Leitung vom restlichen Energieversorgungsnetz zu trennen.

Wichtig im Zusammenhang mit der Erkennung von Fehlern in Energieversorgungsnetzen ist neben der Frage, ob überhaupt ein Fehler aufgetreten ist, auch die Frage nach einer Fehlerart des Fehlers. Eine Fehlerart charakterisiert den vorliegenden Fehler konkreter und gibt beispielsweise an, in welcher möglichen Fehlerschleife des mehrphasigen Energieversorgungsnetzes und/oder in welcher Richtung von der Messstelle aus gesehen der Fehler vorliegt. Bei einem dreiphasigen Energieversorgungsnetz mit drei Leitern (Leiter 1, Leiter 2, Leiter 3) existieren abhängig von den am Fehler beteiligten Leitern sieben mögliche Fehlerschleifen; in nachfolgender Aufstellung sind jeweils die möglichen an einem Fehler beteiligten Leiter sowie die jeweilige in diesem Dokument für die fragliche Fehlerschleife verwendete Abkürzung angegeben:

| | |
|---|---|
| Einpoliger Fehler Leiter 1 - Erde: | L1E; |
| Einpoliger Fehler Leiter 2 - Erde: | L2E; |
| Einpoliger Fehler Leiter 3 - Erde: | L3E; |
| Zweipoliger Fehler Leiter 1 - Leiter 2: | L12; |
| Zweipoliger Fehler Leiter 2 - Leiter 3: | L23; |
| Zweipoliger Fehler Leiter 3 - Leiter 1: | L31; |
| Dreipoliger Fehler Leiter 1 - Leiter 2 - Leiter 3: | L123. |

In Abhängigkeit von einer erkannten Fehlerart kann ein vorliegender Fehler in dem Energieversorgungsnetz selektiv, d.h. auf die von dem Fehler betroffenen Leiter und/oder in der entsprechenden Richtung von der Messstelle aus gesehen abgeschaltet werden, so dass ein Weiterbetrieb der übrigen Netzteile ermöglicht wird.

Aus der Europäischen Patentschrift EP 2 304 857 B1 ist es bekannt, die Fehlerart eines Fehlers in Form einer fehlerbehafteten Schleife durch die Betrachtung einer sogenannten Impedanzänderungsrate zu erkennen. Diejenige Schleife, die die kleinste Impedanzänderungsrate aufweist, wird als fehlerbehaftete Schleife ausgewählt und es wird ein die Fehlerart (hier: Fehler liegt in der erkannten Schleife vor) angebendes Fehlersignal erzeugt. Gemäß dem bekannten Verfahren wird das Fehlersignal dazu verwendet, eine Blockierung einer zuvor aufgrund einer vorhandenen Netzpendelung blockierten Schutzzone aufzuheben, damit der Fehler abgeschaltet werden kann.

Bei dem bekannten Verfahren verlässt sich die Auswertung hinsichtlich der fehlerbehafteten Schleife ausschließlich auf die Impedanzänderungsrate. Dies birgt die Gefahr, dass bei Fehlern, bei denen die Impedanzänderungsrate kein ausreichendes Schutzkriterium darstellt, eine Fehlentscheidung getroffen wird und somit entweder ungewollt eine Abschaltung eines eigentlich fehlerfreien Netzteils ausgelöst wird oder eine eigentlich notwendige Abschaltung eines fehlerbehafteten Netzteils ungewollt nicht stattfindet.

Aufgrund jüngerer Entwicklungen im Bereich der Energieversorgungsnetze, beispielsweise die Liberalisierung der Stromerzeugungsmärkte und ein damit verbundenes Aufbrechen althergebrachter Stromübertragungsrichtungen im Energieversorgungsnetz durch dezentrale Stromeinspeisung, werden an Schutzeinrichtungen in Energieversorgungsnetzen immer höhere Anforderungen hinsichtlich ihrer Zuverlässigkeit und Selektivität gestellt, so dass eine flexible und adaptive Möglichkeit der Anpassung der jeweils verwendeten Schutzkriterien zur Erkennung einer Fehlerart benötigt wird.

Ausgehend von einem Verfahren und einer Schutzeinrichtung der eingangs angegebenen Art stellt sich an die Erfindung daher die Aufgabe, ein Verfahren sowie eine Schutzeinrichtung anzugeben, um eine zuverlässigere Erkennung der Fehlerart auch bei sich unterschiedlichen Netzbedingungen vornehmen zu können.

Diese Aufgabe wird hinsichtlich des Verfahrens erfindungsgemäß durch ein Verfahren der eingangs genannten Art gelöst, bei dem das Ergebnis der Auswertung des jeweiligen Schutzkriteriums unter Bildung eines gewichteten Ergebnisses mit einem Gewichtungsfaktor multipliziert wird; und für jede mögliche Schleife alle gewichteten Ergebnisse unter Bildung eines Gesamtergebnisses verknüpft werden; das jeweilige Ergebnis der Auswertung des jeweiligen Schutzkriteriums in Form eines schutzkriterienspezifischen Wahrscheinlichkeitswerts gebildet wird, der angibt, mit welcher Wahrscheinlichkeit gemäß dem ausgewerteten Schutzkriterium ein Fehler mit der Fehlerart vorliegt; und das jeweilige Gesamtergebnis in Form eines schleifenspezifischen Wahrscheinlichkeitswerts gebildet wird, der angibt, mit welcher Wahrscheinlichkeit in der betrachteten Schleife ein Fehler mit der Fehlerart vorliegt.

Bei dem erfindungsgemäßen Verfahren nach Anspruch 1 wird in vorteilhafter Weise die Entscheidung über eine Fehlerart nicht lediglich anhand eines einzigen Schutzkriteriums getroffen, sondern unter Verwendung mehrerer Schutzkriterien (mindestens zwei), die je für sich dazu geeignet sind, auf eine Fehlerart in der jeweils ausgewerteten Schleife hinzuweisen. Als unterschiedliche Schutzkriterien werden solche Kriterien angesehen, die dazu geeignet sind, dasselbe Ergebnis mit unterschiedlichen Methoden zu ermitteln. Dabei können die unterschiedlichen Methoden auf der Verwendung unterschiedlicher Messwerte (z.B. Strom, Spannung etc.) und/oder davon abgeleiteter Werte (z.B. Impedanz, Wirkleistung, Blindleistung sowie Effektivwerte, Zeiger, RMS-Werte, Mittelwerte von Strom, Spannung etc.) und/oder auf der Verwendung unterschiedlicher Algorithmen beruhen. Die Auswertung wird für alle möglichen Fehlerschleifen (L1E, L2E, L3E, L12, L23, L31, L123) durchgeführt und das Fehlersignal wird unter Berücksichtigung aller vorliegenden Ergebnisse der geprüften Fehlerkriterien erzeugt. Da die Auswertung unter Verwendung von zumindest zwei Schutzkriterien ausgeführt wird und die Ergebnisse aller Schutzkriterien berücksichtigt werden, lässt sich im Vergleich zur Prüfung nur eines einzigen Kriteriums ein Ergebnis mit signifikant höherer Zuverlässigkeit ermitteln; wenn nämlich eines der Schutzkriterien keine eindeutige Aussage treffen kann, besteht die Möglichkeit, dass diese Unsicherheit durch ein weiteres Schutzkriterium, das sich bei seiner Prüfung z.B. anderer Messwerte bedient, kompensiert werden kann.

Das erfindungsgemäße Verfahren kann außerdem auch sehr flexibel an unterschiedliche Netzsituationen angepasst werden, da die zur Erkennung der Fehlerart verwendeten Schutzkriterien in Abhängigkeit z.B. von der vorliegenden Topologie und/oder Spannungsebene ausgewählt werden können.

Das Fehlersignal kann beispielsweise dazu verwendet werden, für eine bestimmte Schleife einen selektiven Schaltvorgang auszulösen, um einen für diese Schleife erkannten Fehler abzuschalten.

Außerdem kann vorteilhaft eine Priorisierung der einzelnen verwendeten Schutzkriterien vorgenommen werden. Es kann nämlich sein, dass ein bestimmtes Schutzkriterium in den meisten Fehlerfällen mit vergleichsweise hoher Zuverlässigkeit die richtige Fehlerart bestimmt, während ein anderes Schutzkriterium nur in bestimmten Grenzfällen ein deutliches Ergebnis liefert. Erfindungsgemäß kann eine entsprechende Übergewichtung des ersten Schutzkriteriums vorgenommen werden, um die Entscheidung über die Fehlerart vorrangig von diesem Schutzkriterium abhängen zu lassen. Dadurch dass schließlich das Gesamtergebnis für jede mögliche Schleife durch geeignete Verknüpfung, z.B. durch Addition, aus allen gewichteten Ergebnissen zusammengesetzt wird, lässt sich erreichen, dass pro Schleife nur ein Ergebnis (das Gesamtergebnis) vorliegt und dass dieses Ergebnis - ggf. mit entsprechender Gewichtung - alle Schutzkriterien berücksichtigt, die für die Schleife angewendet worden sind.

Das erfindungsgemäße Verfahren besitzt den Vorteil, dass alle Gesamtergebnisse aller Schleifen miteinander vergleichbar sind. Ein Wahrscheinlichkeitswert wird nämlich immer einen Wert zwischen 0...1 annehmen, so dass auch das Gesamtergebnis, das die gewichteten schutzkriterienspezifischen Wahrscheinlichkeitswerte berücksichtigt, selbst als Wahrscheinlichkeitswert angebbar ist. Dadurch dass Wahrscheinlichkeitswerte verwendet werden, kann zudem auch eine noch bessere Einbeziehung aller Ergebnisse der einzelnen Schutzkriterien in das Gesamtergebnis erfolgen, ein Schutzkriterium gibt nämlich nicht nur binär an, ob eine bestimmte Fehlerart vorliegt oder nicht, sondern mit welcher Wahrscheinlichkeit diese Fehlerart aktuell vorliegt. Durch die Zusammenfassung aller schutzkriterienspezifischen Wahrscheinlichkeitswerte lässt sich der schleifenspezifische Wahrscheinlichkeitswert mit einer höheren Transparenz bilden als bei einer rein binären Betrachtung. Beispielsweise kann vorgesehen sein, dass das Fehlersignal durch Vergleich aller schleifenspezifischen Wahrscheinlichkeitswerte diejenige Schleife ermittelt, deren schleifenspezifischer Wahrscheinlichkeitswert am höchsten ist, und daraufhin die entsprechende Fehlerart für diese Schleife auswählt.

Gemäß einer vorteilhaften Ausführungsform des erfindungsgemäßen Verfahrens ist vorgesehen, dass die Schutzkriterien parallel zueinander ausgewertet werden.

Eine "parallele" Auswertung kann in diesem Fall beispielsweise eine gleichzeitig auf unterschiedlichen Prozessoren oder Prozessorkernen (physikalisch und/oder virtuell) oder in einem Rechenbaustein mit hardwarebestimmter Programmierung (z.B. ASIC, FPGA) ablaufende Ausführung der Schutzkriterien bedeuten. Als parallele Auswertung wird jedoch auch eine sequentiell ablaufende Ausführung der Schutzkriterien (z.B. auf einem oder mehreren Prozessoren oder Prozessorkernen) angesehen, sofern die Ergebnisse aller Schutzkriterien parallel in die endgültige Auswertung einfließen (im Gegensatz beispielsweise zu einer sequentiellen Abarbeitung, bei der ein Ergebnis eines zuerst ausgeführten Schutzkriteriums in die Ausführung des nächsten Schutzkriteriums eingeht).

Durch diese Ausführungsform kann erreicht werden, dass tatsächlich alle Schutzkriterien in die Erzeugung des Fehlersignals einfließen, so dass die Zuverlässigkeit bei der Erzeugung des Fehlersignals noch weiter erhöht wird.

Gemäß einer weiteren vorteilhaften Ausführungsform ist in diesem Zusammenhang zudem vorgesehen, dass das Fehlersignal unter Berücksichtigung der Gesamtergebnisse aller ausgewerteten Schleifen erzeugt wird.

Hierdurch wird sichergestellt, dass das Fehlersignal alle Gesamtergebnisse der einzelnen möglichen Schleifen berücksichtigt und nicht aufgrund des Ergebnisses nur einer Schleife oder nur weniger Schleifen die Fehlerart bestimmt wird. Dadurch dass die einzelnen Gesamtergebnisse wiederum unter Berücksichtigung aller für die betreffende Schleife ausgewerteten Schutzkriterien gebildet werden, kann zudem sichergestellt werden, dass alle einzelnen Schutzkriterien mit ihrer jeweiligen Gewichtung in die Bildung des Fehlersignals eingehen. Beispielsweise kann für die Fehlerart "fehlerbehaftete Schleife" bei der Bildung des Fehlersignals diejenige Schleife ausgewählt werden, deren Gesamt-Ergebnis den höchsten Wert besitzt.

Konkret kann in diesem Zusammenhang zudem vorgesehen sein, dass für jede mögliche Schleife die Gewichtungsfaktoren für alle ausgewerteten Schutzkriterien so gewählt werden, dass ihre Summe 1 ergibt.

Außerdem kann im Zusammenhang mit den Gewichtungsfaktoren vorgesehen sein, dass die Höhe der jeweiligen Gewichtungsfaktoren in Abhängigkeit von der jeweiligen Konfiguration des Energieversorgungsnetzes gewählt wird.

Hierdurch kann ein adaptives Verhalten der das Verfahren ausführenden Schutzeinrichtung erreicht werden, indem auf sich unterscheidende Netzkonfigurationen durch entsprechende Anpassung der Gewichtungsfaktoren und damit der Priorisierung der einzelnen Schutzkriterien reagiert wird. Beispielsweise kann es sinnvoll sein, im Falle einer starken Einspeisung in der Nähe der Messstelle Schutzkriterien, die sich gemessenen Strömen und/oder davon abgeleiteten Werten bedienen im Vergleich zu spannungsbezogenen Schutzkriterien stärker zu gewichten, während bei einer schwachen Einspeisung eher die spannungsbezogenen Schutzkriterien stärker zu gewichten sind. Diese Auswahl der Werte für die Gewichtungsfaktoren kann einmalig (z.B. bei der Inbetriebnahme der Schutzeinrichtung) anhand vorgegebener Netzkonfigurationen und/oder -parameter oder kontinuierlich durchgeführt werden. Durch eine kontinuierliche Anpassung können beispielsweise stark unterschiedliche Einspeise- oder Lastzustände in der Nähe der Messstelle dynamisch in die Priorisierung der Schutzkriterien einbezogen werden.

Eine weitere vorteilhafte Ausführungsform des erfindungsgemäßen Verfahrens sieht vor, dass das Fehlersignal nur dann erzeugt wird, wenn das Gesamtergebnis zumindest einer möglichen Schleife einen Fehlererkennungs-Schwellenwert überschreitet.

Hierdurch wird die Gefahr von Fehlauslösungen signifikant gesenkt, das nicht jede Erhöhung eines Gesamtergebnisses für eine Schleife sofort zu einer Erzeugung des Fehlersignals führt. Erst wenn die Erhöhung des Gesamtergebnisses zumindest einer Schleife derart signifikant ist, dass ein Fehler angenommen werden muss, wird das Fehlersignal erzeugt. Der Fehlererkennungs-Schwellenwert kann hierbei einen fest vorgegebenen Wert besitzen. Alternativ kann der Fehlererkennungs-Schellenwert aber auch dynamisch gebildet werden und beispielsweise relativ im Vergleich zu den Gesamtergebnissen aller Schleifen ermittelt werden oder einen Abstand des Gesamtergebnisses einer Schleife von den Gesamtergebnissen anderer Schleifen berücksichtigen.

Eine weitere vorteilhafte Ausführungsform des erfindungsgemäßen Verfahrens besteht darin, dass ein jeweiliges Schutzkriterium nur dann ausgewertet wird, wenn alle zu seiner Auswertung erforderlichen Messwerte und/oder abgeleiteten Werte vorliegen.

Hierdurch können solche Schutzkriterien, die - beispielsweise aufgrund fehlender Messwerte und/oder abgeleiteter Werte - nicht anwendbar sind, von der Auswertung temporär ausgenommen werden.

Hinsichtlich der Bildung von Gewichtungsfaktoren kann zudem auch vorgesehen sein, dass ein jeweiliges Schutzkriterium nur dann ausgewertet wird, wenn alle zu seiner Auswertung erforderlichen Messwerte und/oder abgeleiteten Werte vorliegen; und das Gesamtergebnis nur unter Verwendung von gewichteten Ergebnissen solcher Schutzkriterien gebildet wird, die ausgewertet worden sind.

In diesem Fall kann nämlich vorgesehen sein, dass die Gewichtungsfaktoren der übrigen Schutzkriterien, die tatsächlich ausgewertet worden sind, angepasst werden, um so die fehlende Auswertung eines wegen nicht vorliegender Messwerte und/oder abgeleiteter Werte ausgeschlossenen Schutzkriteriums zu kompensieren. Die Gewichtung des ausgeschlossenen Schutzkriteriums wird in einem solchen Fall gemäß der Gewichtungen der angewendeten Schutzkriterien auf diese verteilt.

Es kann beispielsweise vorgesehen sein, dass das Fehlersignal als Fehlerart die Richtung eines Fehlers angibt.

Schutzkriterien, die zur Erkennung der Fehlerart "Fehlerrichtung" geeignet sind, sind beispielsweise die nachfolgend aufgeführten.
- Kurzschlussgetreue aktuelle Spannung: Dieses Schutzkriterium bestimmt das Verhältnis zwischen dem aktuellen Spannungszeiger und dem aktuellen Stromzeiger. Die berechnete Impedanz gibt Aufschluss über die Fehlerrichtung.
- Kurzschlussgetreue gespeicherte Spannung: Dieses Schutzkriterium bestimmt das Verhältnis zwischen dem gespeicherten Spannungszeiger und dem aktuellen Stromzeiger. Dabei wird der an die aktuelle Phasenlage angepasste Spannungszeiger verwendet. Die berechnete Impedanz gibt Aufschluss über die Fehlerrichtung. Sie wird bevorzugt bei serienkompensierten Netzen angewendet.

- Kurzschlussfremde aktuelle Spannung: Dieses Schutzkriterium bestimmt das Verhältnis zwischen dem um 90° gedrehten aktuellen fehlerfremden Spannungszeiger und dem aktuellen Stromzeiger. Die berechnete Impedanz gibt Aufschluss über die Fehlerrichtung. Das Verfahren funktioniert nur bei 1-poligen und 2-poligen Fehlern ohne Erdbeteiligung.
- Kurzschlussfremde gespeicherte Spannung: Dieses Schutzkriterium bestimmt das Verhältnis zwischen dem um 90° gedrehten gespeicherten fehlerfremden Spannungszeiger und dem aktuellen Stromzeiger. Die berechnete Impedanz gibt Aufschluss über die Fehlerrichtung. Das Verfahren funktioniert nur bei 1-poligen und 2-poligen Fehlern ohne Erdbeteiligung
- Deltagrößenkriterium: Die Richtungsbestimmung mit Deltagrößen arbeitet mit statischen oder dynamischen Deltagrößen. Bei der Richtungsbestimmung mit statischen Deltagrößen werden die Deltazeiger von Strom und Spannung verwendet. Die Deltazeiger von Strom und Spannung berechnen sich aus der Differenz zwischen dem aktuellen gemessenen Zeiger und dem vor Fehlerbeginn gespeicherten Zeiger. Das Verhältnis zwischen dem Deltaspannungszeiger und dem Deltastromzeiger gibt Aufschluss über die Fehlerrichtung. Bei der Richtungsbestimmung mit dynamischen Deltagrößenwerden die Delta-Abtastwerte von Strom und Spannung verwendet. Die Delta-Abtastwerte von Strom und Spannung berechnen sich aus der Differenz zwischen dem aktuellen gemessenen Abtastwert und dem vor einer Netzperiode erfassten Abtastwert. Das Produkt aus Deltastrom und Deltaspannung wird integriert. Das Ergebnis der Integration gibt Aufschluss über die Fehlerrichtung.
- Symmetrische Komponenten-Kriterium: Die Richtungsbestimmung basiert auf den symmetrischen Komponenten. Bei der Richtungsbestimmung mit Nullsystemgrößen wird die Nullsystemimpedanz aus den Spannungs- und Stromzeigern des Nullsystems bestimmt.

Die berechnete Impedanz gibt Aufschluss über die Fehlerrichtung. Das Verfahren funktioniert nur bei Fehlern mit Erdbeteiligung. Bei der Richtungsbestimmung mit Gegensystemgrößen wird die Gegensystemimpedanz aus den Spannungs- und Stromzeigern des Gegensystems bestimmt. Die berechnete Impedanz gibt Aufschluss über die Fehlerrichtung. Sie wird bevorzugt bei Kurzschlüssen während Netzpendelungen angewendet. Sie funktioniert nur bei unsymmetrischen Kurzschlüssen.
- Delta-Mitsystemgrößen-Kriterium: Bei der Richtungsbestimmung mit Delta-Mitsystemgrößen wird das Verhältnis zwischen dem Delta-Spannungszeiger und dem Delta-Stromzeiger des Mitsystems bestimmt. Die berechnete Impedanz gibt Aufschluss über die Fehlerrichtung.

Die Richtung des Fehlers kann hierbei als "vorwärts", "rückwärts" oder "ungerichtet", jeweils von der Messstelle aus gesehen, angegeben werden. Eine ungerichtete Richtung erlaubt keine konkrete Festlegung auf einen Vorwärts- oder Rückwärtsfehler.

Außerdem kann auch vorgesehen sein, dass das Fehlersignal als Fehlerart die fehlerbehaftete Schleife angibt.

Schutzkriterien, die zur Erkennung der Fehlerart "fehlerbehaftete Schleife" geeignet sind, sind beispielsweise die nachfolgend aufgeführten.
- Stromhöhenkriterium: Dieses Schutzkriterium basiert auf der Annahme, dass bei einem Fehler der Strom in den fehlerbehafteten Schleifen ansteigt. Dabei gibt z.B. das Verhältnis aus Stromeffektivwert und Nennstrom Aufschluss über die fehlerbehaftete Schleife.
- Spannungshöhenkriterium: Dieses Schutzkriterium basiert auf der Annahme, dass bei einem Fehler die Spannung in den fehlerbehafteten Schleifen einbricht. Dabei gibt z.B. das Verhältnis aus Spannungseffektivwert und Nennspannung Aufschluss über die fehlerbehaftete Schleife.

- Delta-Stromhöhenkriterium: Bei diesem Schutzkriterium werden die sogenannten "Deltagrößen" der Ströme herangezogen. Große Deltagrößen weisen auf signifikante Sprünge im Stromverlauf für die betrachtete Schleife und damit auf einen möglichen Fehler hin. Folgende Deltagrößen können z.B. gebildet werden: Differenz aus dem aktuellen Effektivwert des Stroms und einem gespeicherten zeitlich (z.B. eine Periode) vorangehenden Effektivwert des Stroms; Differenz aus dem aktuellen Momentanwert des Stroms und dem eine Nominalperiode zurückliegenden gespeicherten Momentanwert des Stroms; Differenz aus momentanen Zeigerwerten des Stroms und einem gespeicherten Zeigerwert des Stroms. Die Höhe der jeweils berechneten Deltagrößen gibt Aufschluss über die fehlerbehaftete Schleife.
- Delta-Spannungshöhenkriterium: Bei diesem Schutzkriterium werden die Deltagrößen der Spannungen herangezogen. Große Deltagrößen weisen auf signifikante Sprünge im Spannungsverlauf für die betrachtete Schleife und damit auf einen möglichen Fehler hin. Folgende Deltagrößen können z.B. gebildet werden: Differenz aus dem aktuellen Effektivwert der Spannung und einem gespeicherten zeitlich (z.B. eine Periode) vorangehenden Effektivwert der Spannung; Differenz aus dem aktuellen Momentanwert der Spannung und dem eine Nominalperiode zurückliegenden gespeicherten Momentanwert der Spannung; Differenz aus momentanen Zeigerwerten der Spannung und einem gespeicherten Zeigerwert der Spannung. Die Höhe der berechneten Deltagrößen gibt Aufschluss über die fehlerbehaftete Schleife.
- Impedanzkriterium: Dieses Schutzkriterium berechnet Impedanzen für alle Fehlerschleifen. Dabei gibt das Verhältnis aus dem niedrigsten Impedanzwert und der jeweils berechneten Schleifenimpedanz Aufschluss über die fehlerbehaftete Schleife.
- Symmetrische Komponenten-Kriterium: Dieses Schutzkriterium basiert auf den symmetrischen Komponenten. Das Verhältnis zwischen Null-, Gegen- und Mitsystemzeiger von Strom oder Spannung gibt Aufschluss über die fehlerbehaftete Schleife.
- Sprungerkennung: Dieses Schutzkriterium ist ein logisches Kriterium, das Strom- und Spannungssprünge als Eingangsgrößen hat. Anhand einer logischen Verknüpfung der vorhandenen Strom- und Spannungssprünge wird auf die fehlerbehaftete Schleife geschlossen.

Im Fall der Fehlerart "fehlerbehaftete Schleife" ergibt die Auswertung der Schutzkriterien für eine bestimmte Schleife - ggf. durch zusätzlichen Vergleich mit den Auswertungen der übrigen Schleifen - direkt die Fehlerart, nämlich eine Entscheidung darüber, ob die betreffende Schleife von einem Fehler betroffen ist oder nicht. Eine zusätzliche Unterteilung der Fehlerart wie bei der Fehlerrichtung ist hier nicht erforderlich.

Eine weitere vorteilhafte Ausführungsform des erfindungsgemäßen Verfahrens sieht außerdem vor, dass ein erstes Fehlersignal erzeugt wird, das als Fehlerart die Richtung eines Fehlers angibt, ein zweites Fehlersignal erzeugt wird, das als Fehlerart die fehlerbehaftete Schleife angibt, und ein Gesamt-Fehlersignal unter Berücksichtigung des ersten und des zweiten Fehlersignals erzeugt wird.

Bei dieser Ausführungsform wird das voranstehend beschriebene erfindungsgemäße Verfahren oder eine seiner Ausführungsformen einmal zur Bildung eines Fehlersignals bezüglich der Richtung eines Fehlers und einmal zur Bildung eines Fehlersignals bezüglich der Erkennung einer von dem Fehler behafteten Schleife angewendet. Durch Kombination beider Fehlersignale kann ein Gesamt-Fehlersignal erzeugt werden, das einerseits die fehlerbehaftete Schleife und andererseits die Richtung, in der der Fehler in dieser Schleife liegt, angibt.

In diesem Zusammenhang kann gemäß einer weiteren vorteilhaften Ausführungsform des erfindungsgemäßen Verfahrens vorgesehen sein, dass mittels der Auswerteinrichtung auch geprüft wird, ob ein Fehler in einer unmittelbar von der Schutzeinrichtung überwachten Schutzzone des Energieversorgungsnetzes vorliegt und ein Fehlerzonensignal erzeugt wird, wenn ein Fehler in der Schutzzone vorliegt, und das Gesamt-Fehlersignal auch unter Berücksichtigung des Fehlerzonensignals erzeugt wird.

Auf diese Weise kann auch die Entscheidung darüber, ob der Fehler überhaupt in der Schutzzone der Schutzeinrichtung liegt (interner Fehler), oder ob er außerhalb der Schutzzone der Schutzeinrichtung liegt (externer Fehler), in die Bildung des Gesamt-Fehlersignals einbezogen werden. Die Erkennung der Schutzzone kann beispielsweise anhand des eingangs beschriebenen Distanzschutzverfahrens unter Verwendung der aus Strom und Spannung für die Messstelle ermittelten Impedanz erfolgen. Durch Betrachtung aller drei Gesichtspunkte, der betroffenen Schutzzone in Verbindung mit den ermittelten Fehlerarten bezüglich Richtung und betroffener Schleife, kann der Fehler selektiv erkannt und abgeschaltet werden.

Die oben genannte Aufgabe wird auch durch eine Schutzeinrichtung zum Erzeugen eines eine Fehlerart eines Fehlers in einem mehrphasigen elektrischen Energieversorgungsnetz angebenden Fehlersignals mit einer Messwerterfassungseinrichtung zum Erfassen von an mindestens einer Messstelle in dem Energieversorgungsnetz aufgenommener Messwerte, die einen aktuellen Betriebszustand des Energieversorgungsnetzes beschreiben, und einer Auswerteinrichtung, die dazu eingerichtet ist, unter Verwendung der Messwerte jede mögliche Schleife des Energieversorgungsnetzes, die von einem Fehler betroffen sein kann, hinsichtlich der Erkennung der Fehlerart eines Fehlers auszuwerten und bei Vorliegen eines Fehlers das Fehlersignal zu erzeugen, gelöst.

Erfindungsgemäß ist vorgesehen, dass die Auswerteinrichtung dazu eingerichtet ist, ein Verfahren nach einem der Ansprüche 1 bis 12 auszuführen.

Hinsichtlich der erfindungsgemäßen Schutzeinrichtung gelten alle zu dem erfindungsgemäßen Verfahren voranstehend und nachfolgend gemachten Ausführungen und umgekehrt in entsprechender Weise, insbesondere ist die erfindungsgemäße Schutzeinrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Schutzeinrichtung wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Schutzeinrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen
- Figur 1: eine schematische Ansicht eines von einer Schutzeinrichtung überwachten Teils eines elektrischen Energieversorgungsnetzes;
- Figur 2: ein schematisches Ablaufblockschaltbild zur Erläuterung eines Verfahrens zum Erzeugen eines die Fehlerart eines Fehlers angebenden Fehlersignals;
- Figuren 3, 4: Diagramme zur Erläuterung der Verwendung von Gewichtungsfaktoren;
- Figuren 5-8: Diagramme zur Erläuterung der Ermittlung von schutzkriterienspezifischen Wahrscheinlichkeitswerten für die Fehlerart "fehlerbehaftete Schleife";
- Figuren 9-11: Messwertverläufe und Diagramme zur Erläuterung der Erzeugung eines Fehlersignals für die Fehlerart "fehlerbehaftete Schleife";
- Figur 12: ein schematisches Ablaufblockschaltbild zur Erläuterung der Erzeugung eines Fehlersignals für die Fehlerart "Fehlerrichtung";
- Figuren 13-16: Diagramme zur Erläuterung der Ermittlung von schutzkriterienspezifischen Wahrscheinlichkeitswerten für die Fehlerart "Fehlerrichtung"; und
- Figur 17: ein schematisches Ablaufblockschaltbild zur Erläuterung der Erzeugung eines einzelnen Fehlersignals berücksichtigenden Gesamt-Fehlersignals.

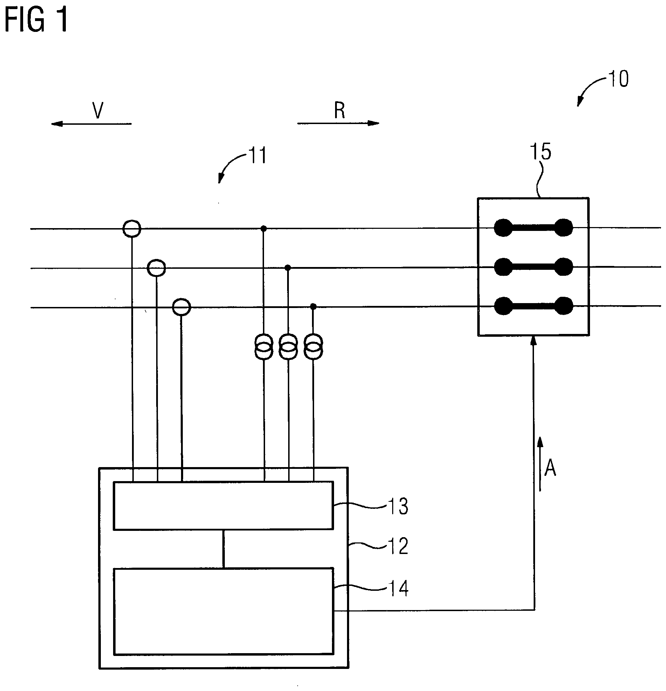

Figur 1 zeigt in schematischer Ansicht einen Netzteil eines ansonsten nicht näher dargestellten elektrischen Energieversorgungsnetzes. Bei dem dargestellten Netzteil 10 handelt es sich beispielhaft um eine Energieversorgungsleitung, die z.B. als Freileitung oder als Erdkabel ausgeführt sein kann. An einer Messstelle 11 werden mittels nur schamtisch angedeuteter Messwandler Messwerte, die den Zustand des Energieversorgungsnetzes an der Messstelle 11 angeben, erfasst. Bei den Messwerten kann es sich z.B. um elektrische Ströme und/oder Spannungen handeln. Die erfassten Messwerte werden einer Schutzeinrichtung 12 zugeführt, bei der es sich z.B. um ein Distanzschutzgerät handeln kann, und dort mittels einer Messwerterfassungseinrichtung 13 erfasst. In der Messwerterfassungseinrichtung findet eine Vorverarbeitung, z.B. A/D-Wandlung, Filterung, Berechnung von abgeleiteten Werten (Mittelwerten, RMS-Werten, Effektivwerten, Zeigerwerten, symmetrischen Komponenten, Impedanzen, Leistungen etc.), statt. Die vorverarbeiteten Messwerte und ggf. die abgeleiteten Werte werden an eine Auswerteinrichtung 14 übergeben, die hinsichtlich der übergebenen Messwerte und abgeleiteten Werte eine Auswertung auf möglicherweise in einer Schutzzone der Schutzeinrichtung 12 vorliegende Fehler durchführt. Dabei kann beispielsweise ein an sich bekannter Distanzschutzalgorithmus durchgeführt werden, mit dem unter Verwendung von aus Stromzeigern und Spannungszeigern berechneter komplexer Impedanzwertauf das Vorliegen von Fehlern geschlossen wird. Dabei ist einerseits zu bestimmen, ob der Fehler innerhalb oder außerhalb einer überwachten Schutzzone der Schutzeinrichtung liegt. Nur bei innerhalb der Schutzzone liegenden Fehlern ist die Schutzeinrichtung selbst vorrangig für die Fehlerklärung verantwortlich. Die Entscheidung darüber, ob der Fehler innerhalb der Schutzzone vorliegt, wird bei einem Distanzschutzgerät üblicherweise anhand der Lage des Impedanzwertes in der komplexen Ebene Impedanzebene getroffen. Andererseits sind Fehlerarten des Fehlers, insbesondere die Richtung (Vorwärtsrichtung V; Rückwärtsrichtung R), in der der Fehler von der Messstelle aus gesehen liegt, und die von dem Fehler betroffene Schleife (L1E, L2E, L3E, L12, L23, L34, L123) zu ermitteln. Wenn die Schutzeinrichtung 12 anhand aller benötigten Informationen einen innerhalb der Schutzzone liegenden Fehler in Vorwärtsrichtung und in einer bestimmten Schleife feststellt, so kann sie mittels eines Auslösesignals A einen Leistungsschalter 15 zum selektiven Öffnen derjenigen Schaltkontakte veranlassen, die die fehlerbehafteten Leiter vom übrigen Energieversorgungsnetz abtrennen.

Die Messwerterfassungseinrichtung 13 und die Auswerteinrichtung 14 müssen nicht als getrennte Einrichtungen ausgeführt sein, sondern können auch eine integrierte Einrichtung bilden. Die Funktionen der Messwerterfassungseinrichtung 13 und der Auswerteinrichtung 14 können durch hardwarebestimmte Programmierung (z.B. ASIC, FPGA), durch softwarebestimmte Programmierung eines Prozessors (z.B. Microprozessor, CPU, Digital Signal Processor (DSP)) oder einer Kombination daraus festgelegt werden.

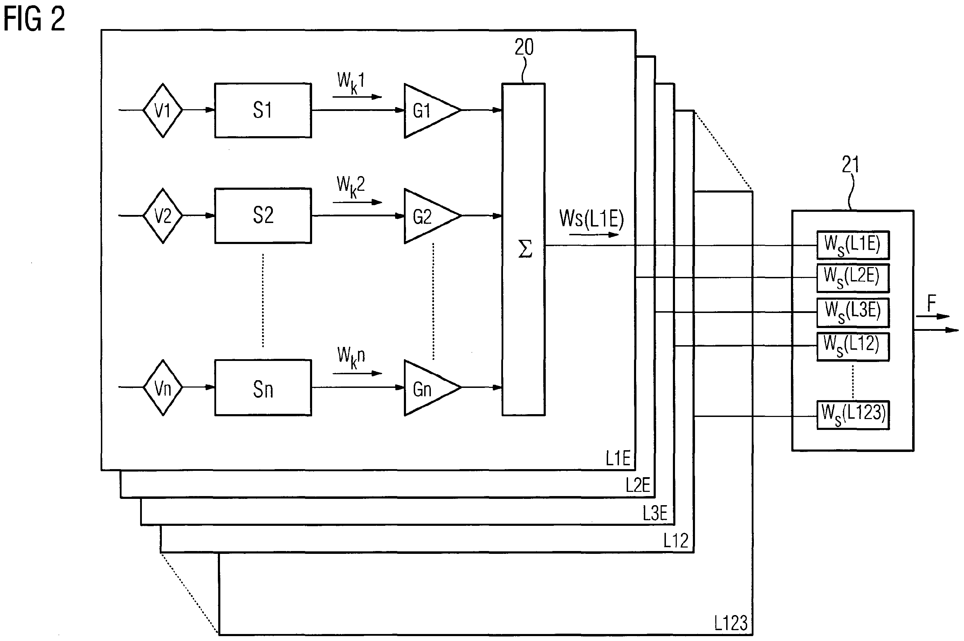

Figur 2 zeigt beispielhaft in Form eines Ablaufblockschaltbildes eine von der Auswerteinrichtung 14 ausgeführte Funktion zur Ermittlung der Fehlerart eines Fehlers und zur Erzeugung eines die ermittelte Fehlerart angebenden Fehlersignals F. Die Erkennung der Fehlerart wird für alle möglichen Schleifen, in denen ein Fehler auftreten kann, also L1E, L2E, L3E, L12, L23, L31, L123, durchgeführt. Nachfolgende Erläuterungen beziehen sich zunächst auf die mögliche Schleife L1E.

Im Gegensatz zu bisherigen Ansätzen werden zur Ermittlung der Fehlerart eines Fehlers gemäß dem in Figur 2 gezeigten Ablaufblockschaltbild mehrere unterschiedliche Schutzkriterien S1, S2, ... Sn parallel zueinander ausgewertet. Auf Beispiele von einzelnen Schutzkriterien wird an späterer eingegangen. Jedes Schutzkriterium ist für sich selbständig dazu geeignet, eine Aussage über die Fehlerart eines vorliegenden Fehlers zu treffen, verwendet dazu aber unterschiedliche Eingangsgrößen (Messwerte bzw. abgeleitete Werte) und/oder Algorithmen. Die Ergebnisse der Auswertungen der unterschiedlichen Schutzkriterien S1...Sn werden in Form von schutzkriterienspezifischen Wahrscheinlichkeitswerten W_{·k·}1...W_{·k·}n ausgegeben, die jeweils angeben, mit welcher Wahrscheinlichkeit gemäß dem ausgewerteten Schutzkriterium die Fehlerart vorliegt. Daraufhin findet eine Multiplikation der schutzkriterienspezifischen Wahrscheinlichkeitswerte mit geeigneten Gewichtungsfaktoren G1...Gn statt, um eine Priorisierung der einzelnen Schutzkriterien S1...Sn vorzunehmen. Auf diese Weise kann den Ergebnissen einzelner Schutzkriterien gezielt ein stärkeres Gewicht verliehen werden als den Ergebnissen anderer Schutzkriterien. Sofern keine Priorisierung erfolgen soll, kann auch auf die Gewichtung verzichtet werden oder es können identische Gewichtungsfaktoren G1...Gn für alle Schutzkriterien verwendet werden. Generell bietet es sich an, die Gewichtungsfaktoren so zu wählen, dass ihre Summe 1 ergibt; eine Auswahl anderer Gewichtungsfaktoren ist jedoch auch möglich.

Die gewichteten schutzkriterienspezifischen Wahrscheinlichkeitswerte W.ₖ.1...W.ₖ.n werden daraufhin einem Summationsblock 20 zugeführt, der die Summe der einzelnen schutzkriterienspezifischen Wahrscheinlichkeitswerte W.ₖ.1...W.ₖ.n unter Bildung eines Gesamt-Ergebnisses in Form eines schleifenspezifischen Wahrscheinlichkeitswertes W_{·s·}(L1E) bestimmt, der angibt, mit welcher Wahrscheinlichkeit für die betrachtete Schleife die Fehlerart vorliegt.

Die beispielhaft für die Schleife L1E erläuterte Vorgehensweise findet auch für alle anderen möglichen Schleifen, in denen ein Fehler auftreten kann, also auch für die Schleifen L2E, L3E, L12, L23, L31, L123 statt, wie in Figur 2 durch mehrere Ebenen des Ablaufblockschaltbildes angedeutet wird. Für jede Schleife wird in der beschriebenen Weise ein schleifenspezifischer Wahrscheinlichkeitswert W_{·s·}(L1E)...W_{·s·}(L123) ermittelt und ausgegeben. In einem nachfolgenden Kombinationsblock 21 werden die jeweiligen schleifenspezifischen Wahrscheinlichkeitswerte gesammelt und ausgewertet. Unter Berücksichtigung aller schleifenspezifischen Wahrscheinlichkeitswerte W_{·s·}(L1E)...W_{·s·}(L123) wird schließlich das die Fehlerart angebende Fehlersignal F gebildet. Das erzeugte Fehlersignal F gibt die unter Berücksichtigung aller schleifenspezifischen Wahrscheinlichkeitswerte (und damit auch unter Berücksichtigung aller schutzkriterienspezifischen Wahrscheinlichkeitswerte aller Schleifen) ermittelte Fehlerart an, damit unter Berücksichtigung dieses Fehlersignals ein etwaiges Auslösesignal A für einen Schalter erzeugt werden kann.

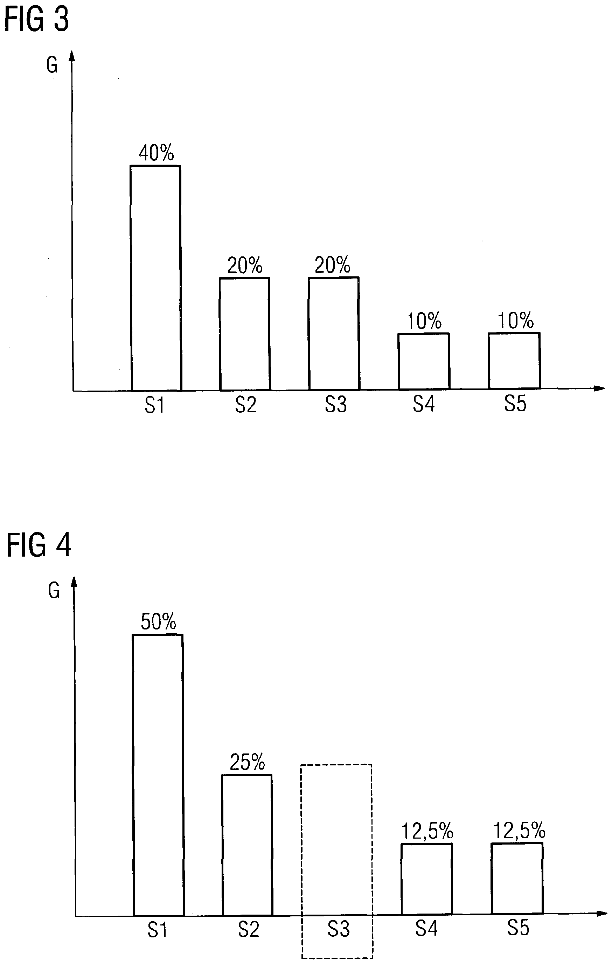

Sofern für die Anwendung eines bestimmten Schutzkriteriums Sl...Sn die notwendigen Messwerte und/oder abgeleiteten Werte nicht vorhanden sind, ist es möglich, das fragliche Schutzkriterium temporär aus der Auswertung herauszunehmen. Fehlende Messwerte und/oder abgeleitete Werte können beispielsweise durch (noch) nicht vorliegende abgespeicherte Werte oder durch fehlerhafte Messwerterfassung oder generell fehlende Messkanäle hervorgerufen werden. Die diesbezügliche Prüfung findet in den Schutzkriterien S1...Sn vorgelagerten Vorbedingungsprüfungs-Blöcken V1...Vn statt. Sofern in einem solchen Vorbedingungsprüfungs-Block V1...Vn festgestellt wird, dass die notwendigen Messwerte und/oder abgeleiteten Werte zur Ausführung des Schutzkriteriums nicht vorliegen, wird dieses vorübergehend deaktiviert, bis die notwendigen Messwerte und/oder abgeleiteten Werte wieder vorliegen. Außerdem können die Gewichtungsfaktoren G1...Gn der tatsächlich verwendeten Schutzkriterien derart angepasst werden, dass ihre Summe auch ohne Berücksichtigung des Gewichtungsfaktors des deaktivierten Schutzkriteriums wieder 1 ergibt. Dies ist in Figuren 3 und 4 beispielhaft erläutert. Hier sind in Diagrammform die Gewichtungsfaktoren für fünf beispielhafte Schutzkriterien S1...S5 bei Auswertung aller Schutzkriterien (Figur 3) und nach Deaktivierung des Schutzkriteriums S3 (Figur 4) aufgrund dafür fehlender notwendiger Messwerte und/oder abgeleiteter Werte dargestellt. Die Werte der Gewichtungsfaktoren sind jeweils im Diagramm angegeben. Im Normalfall bei Verwendung aller Schutzkriterien besitzen alle Gewichtungsfaktoren Werte größer als Null. In dem Fall, dass ein Schutzkriterium (hier S3) nicht angewendet wird, wird dessen Gewichtungsfaktor auf 0% gesetzt, die übrigen Gewichtungsfaktoren teilen sich den Wert des herausgefallenen Gewichtungsfaktors (hier 20%) entsprechend ihrer Gewichtung untereinander auf, so dass die Summe aller verbleibenden Gewichtungsfaktoren erneut eins ergibt. Durch die Anpassung der Gewichtungsfaktoren wird erreicht, dass ein deaktiviertes Kriterium das Gesamtergebnis nicht beeinflusst.

Die Gewichtungsfaktoren können entweder fest vorgegeben sein und sich beispielsweise aus Erfahrungswerten, die mit ähnlichen Netzkonfigurationen gemacht worden sind, ableiten. Die Gewichtungsfaktoren können jedoch auch abhängig von der jeweiligen spezifischen Netzkonfiguration ausgewählt werden oder sogar dynamisch an sich ändernde Netzbedingungen, z.B. starke/schwache Einspeisung, Lastsituation, Änderungen der Netztopologie, angepasst werden.

Nachfolgend wird die in Figur 2 dargestellte Vorgehensweise am Beispiel der Fehlerart "fehlerbehaftete Schleife" näher erläutert. In diesem Fall sind die einzelnen Schutzkriterien S1...Sn jeweils für sich dazu geeignet, festzustellen, ob die betrachtete Schleife von einem Fehler betroffen ist. Zunächst wird dabei die Vorgehensweise für die mögliche Schleife S1 dargestellt.

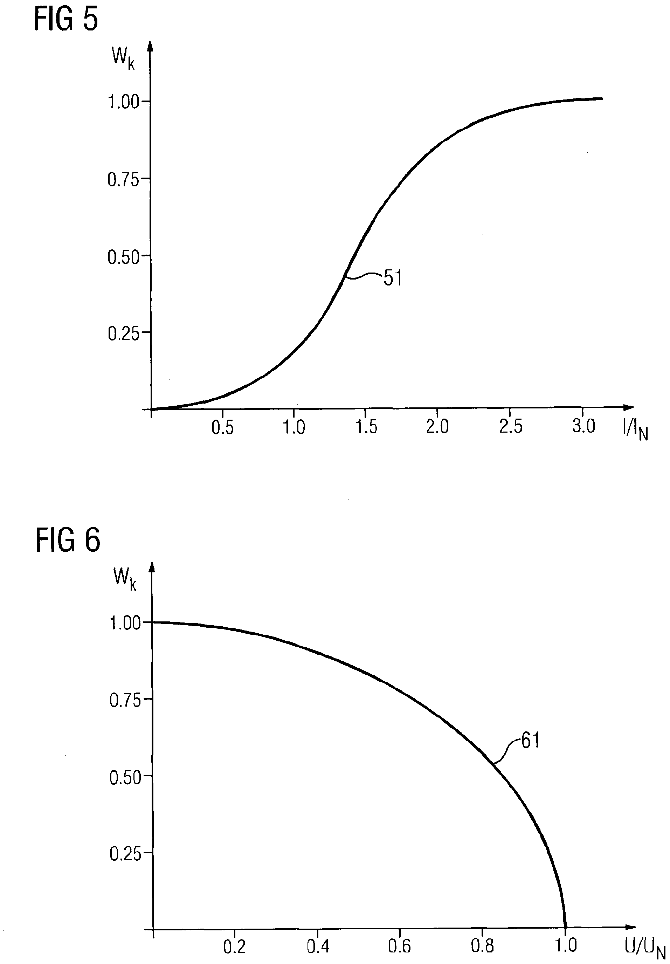

Beispielsweise kann das erste Schutzkriterium S1 ein Stromhöhenkriterium sein und die Höhe des aktuell gemessenen Stroms I (als auf den Nennstrom I_{·N·} bezogener Effektivwert) betrachten. Ein hoher Strom deutet auf einen die geprüfte Schleife betreffenden Fehler hin. In Figur 5 ist beispielhaft ein Diagramm mit einer Kennlinie 51 dargestellt. Hier ist gezeigt, wie das erste Schutzkriterium S1 aus der Höhe des Stroms I/I_{·N·} die Höhe eines schutzkriterienspezifischen Wahrscheinlichkeitswertes W_{·k·}1 ermittelt. Man erkennt, dass mit steigendem Strom I/I_{·N·} die Wahrscheinlichkeit, dass die fragliche Schleife an einem Fehler beteiligt ist, ebenfalls ansteigt, bis sie bei signifikanter Höhe des Stroms (hier bei I etwa 3*I_{·N·}) bei 1 liegt. Der entsprechend der Kennlinie 51 in dem Diagramm ermittelte schutzkriterienspezifische Wahrscheinlichkeitswert W_{·k·}1 wird vom Block S1 (vgl. Figur 2) abgegeben, mit dem Gewichtungsfaktor G1 multipliziert und dem Summationsblock 20 zugeführt.

Das zweite Schutzkriterium S2 kann beispielsweise ein Spannungshöhenkriterium sein und die Höhe der aktuell gemessenen Spannung U (als auf die Nennspannung U_{·N·} bezogener Effektivwert) betrachten. Eine niedrige Spannung deutet auf einen die geprüfte Schleife betreffenden Fehler hin. In Figur 6 ist beispielhaft ein Diagramm mit einer Kennlinie 61 dargestellt. Hier ist gezeigt, wie das zweite Schutzkriterium S2 aus der Höhe der Spannung U/U_{·N·} die Höhe des schutzkriterienspezifischen Wahrscheinlichkeitswerts W_{·k·}2 ermittelt. Man erkennt, dass mit abnehmender Spannung U/U_{·N·} die Wahrscheinlichkeit, dass die fragliche Schleife an einem Fehler beteiligt ist, ansteigt, bis sie bei sehr kleiner Spannung schließlich bei 1 liegt. Der entsprechend der Kennlinie 61 in dem Diagramm ermittelte schutzkriterienspezifische Wahrscheinlichkeitswert W_{·k·}2 wird vom Block S2 abgegeben, mit dem Gewichtungsfaktor G2 multipliziert und dem Summationsblock 20 zugeführt.

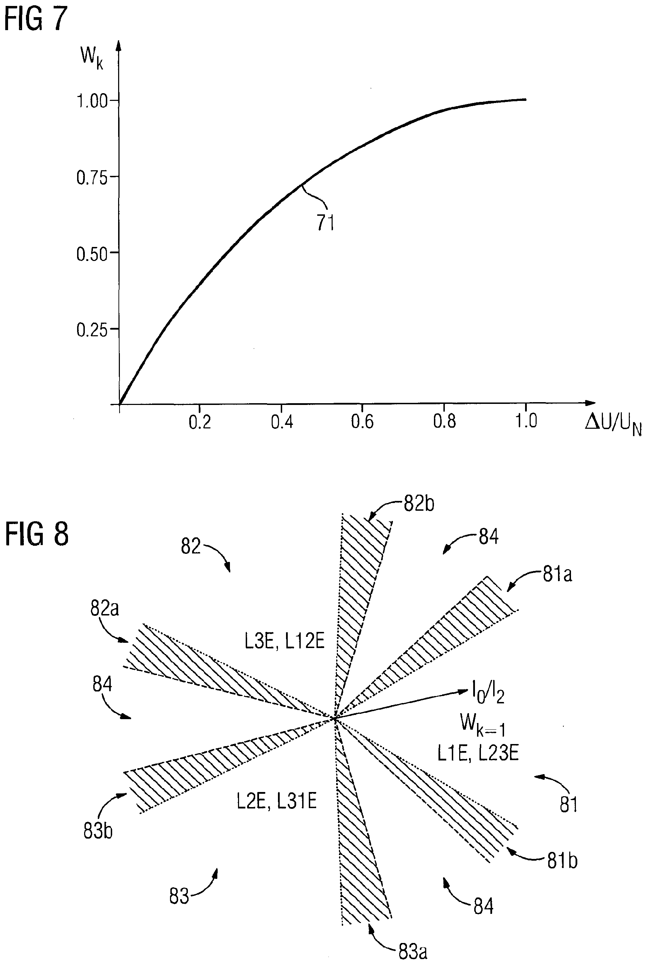

Als ein drittes Schutzkriterium S3 (in Figur 2 nicht dargestellt) kann beispielsweise ein Delta-Spannungshöhenkriterium verwendet werden. Bei diesem Schutzkriterium werden die Deltagrößen der Spannungen herangezogen. Große Deltagrößen weisen auf signifikante Sprünge im Spannungsverlauf für die betrachtete Schleife und damit auf einen möglichen Fehler hin. Die Deltaspannung ΔU wird hierbei auf die Nennspannung U_{·N·} bezogen. Figur 7 zeigt hierzu ein Diagramm mit einer Kennlinie 71. Hier ist gezeigt, wie das dritte Schutzkriterium S3 aus der Höhe der Deltaspannung ΔU/U_{·N·} die Höhe des schutzkriterienspezifischen Wahrscheinlichkeitswerts W_{·k·}3 ermittelt. Man erkennt, dass mit steigender Deltaspannung ΔU/U_{·N·} die Wahrscheinlichkeit, dass die fragliche Schleife an einem Fehler beteiligt ist, ansteigt, bis sie schließlich bei 1 liegt. Der entsprechend der Kennlinie 71 in dem Diagramm ermittelte schutzkriterienspezifische Wahrscheinlichkeitswert W_{·k·}3 wird mit einem Gewichtungsfaktor G3 (in Figur 2 nicht dargestellt) multipliziert und dem Summationsblock 20 zugeführt.

Als Schutzkriterium Sn schließlich kann beispielsweise ein Symmetrische Komponenten-Kriterium verwendet werden. Dieses Schutzkriterium basiert auf den symmetrischen Komponenten, bei dem das Verhältnis zwischen Null-, Gegen- und Mitsystemzeigern von Strom oder Spannung betrachtet wird. Figur 8 zeigt beispielhaft ein Diagramm, in dem das Verhältnis von Zeigergrößen des Nullsystemstroms und des Gegensystemstroms eingetragen werden kann. Man erkennt im Wesentlichen drei Bereiche 81, 82 und 83, in denen mit dem Symmetrische Komponenten-Kriterium jeweils für jeweils ausgewählte Schleifen mit einer Wahrscheinlichkeit von 1 das Vorliegen eines Fehlers bestimmt werden kann. An den Begrenzungen der jeweiligen Bereiche 81-83 schließen sich Übergangsbereiche 81a,b, 82a,b, 83a,b an, in denen die Wahrscheinlichkeit für eine Fehlerbeteiligung der jeweiligen Schleife von 1 auf 0 abfällt. In den dazwischenliegenden Bereichen 84 ermittelt das Symmetrische Komponenten-Kriterium jeweils eine Wahrscheinlichkeit von 0 für die jeweils betrachtete Schleife, hier kann mit dem Symmetrische Komponenten-Kriterium also keine eindeutige Auswahl getroffen werden. Dies zeigt erneut die Wichtigkeit der Tatsache, dass in die Auswertung hinsichtlich der Fehlerart mehrere Schutzkriterien einbezogen werden und die Ergebnisse der Auswertungen von allen Schutzkriterien in bei der Ermittlung der Fehlerart berücksichtigt wird.

Für den in Figur 8 dargestellten Fall, dass der das Verhältnis aus Nullsystemstrom I_{·0·} und Gegensystemstrom I_{·2·} angebende Zeiger 80 in den Bereich 81 fällt, kann festgestellt werden, dass für die möglichen Schleifen L1E und L23 (mit Erdbeteiligung) jeweils der schutzkriterienspezifische Wahrscheinlichkeitswert von 1 vergeben wird. Der entsprechend ermittelte schutzkriterienspezifische Wahrscheinlichkeitswert W_{·k·}n wird mit einem Gewichtungsfaktor Gn multipliziert und dem Summationsblock 20 zugeführt.

Andere mögliche Schutzkriterien können z.B. ein Delta-Stromhöhenkriterium, ein Impedanzkriterium oder ein Sprungerkennungskriterium sein. Auch die Verwendung anderer geeigneter Schutzkriterien ist selbstverständlich möglich, so dass die Schutzeinrichtung durch Auswahl der passenden Schutzkriterien immer an die durch die Topologie und Konfiguration des überwachten Energieversorgungsnetzes vorgegebenen Bedingungen angepasst werden kann.

Die gewichteten schutzkriterienspezifischen Wahrscheinlichkeitswerte W.ₖ.1...W.ₖ.n werden wie oben bereits erläutert dem Summationsblock 20 zugeführt, der durch Addition den schleifenspezifischen Wahrscheinlichkeitswert W_{·s·}(L1E) für die Schleife L1E bildet.

In entsprechender Weise werden für die anderen Schleifen unter Anwendung derselben oder anderer geeigneter Schutzkriterien schleifenspezifische Wahrscheinlichkeitswerte W_{·s·}(L2E)...W_{·s·}(L123) gebildet. Alle schleifenspezifischen Wahrscheinlichkeitswerte W_{·s·}(L1E)...W_{·s·}(L123) werden in dem Kombinationsblock 21 ausgewertet und bei der Erzeugung des die Fehlerart "fehlerbehaftete Schleife" angebenden Fehlersignals F berücksichtigt. Hierzu kann der Kombinationsblock beispielsweise diejenige Schleife als von einem Fehler behaftet auswählen, die den größten schleifenspezifischen Wahrscheinlichkeitswert aufweist. Um gegen Fehlauslösungen ausreichende Sicherheit zu bieten, kann zudem vorgesehen sein, dass ein Fehlersignal F nur dann erzeugt wird, wenn der größte schleifenspezifische Wahrscheinlichkeitswert einen Fehlererkennungs-Schwellenwert überschreitet. Dieser Schwellenwert kann entweder fest vorgegeben sein oder an die jeweiligen schleifenspezifische Wahrscheinlichkeitswerte angepasst werden (z.B. relative Höhe eines schleifenspezifischen Wahrscheinlichkeitswertes im Vergleich zu allen anderen schleifenspezifischen Wahrscheinlichkeitswerten, Abstand des größten schleifenspezifischen Wahrscheinlichkeitswertes zum zweitgrößten schleifenspezifischen Wahrscheinlichkeitswert etc.).

Das erzeugte Fehlersignal F gibt die unter Berücksichtigung aller schleifenspezifischen Wahrscheinlichkeitswerte (und damit auch unter Berücksichtigung aller schutzkriterienspezifischen Wahrscheinlichkeitswerte aller Schleifen) ermittelte Fehlerart an. Im Fall der eben erläuterten Fehlerart "fehlerbehaftete Schleife" gibt das Fehlersignal folglich die von dem Fehler betroffene Schleife an, damit unter Berücksichtigung dieses Fehlersignals ein etwaiges Auslösesignal A für einen Schalter erzeugt werden kann.

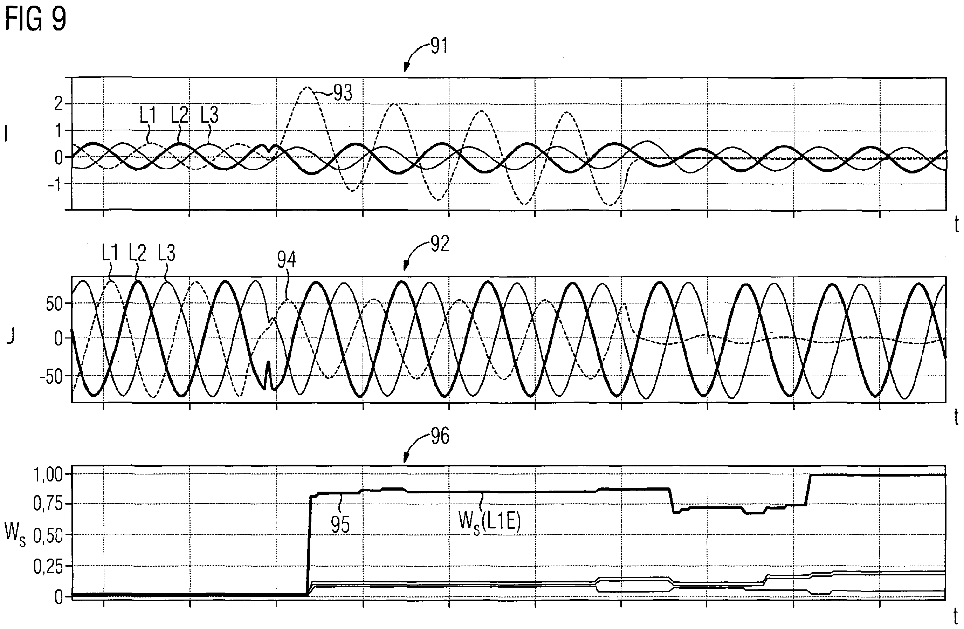

Figuren 9-11 zeigen Diagramme für unterschiedliche Fehlerfälle, bei denen unter Anwendung des oben beschriebenen Verfahrens eine fehlerbehaftete Schleife ermittelt wird.

In Figur 9 sind typische zeitliche Verläufe der Ströme (Diagramm 91) und Spannungen (Diagramm 92) während eines einpoligen Fehlers (L1E) dargestellt. Diagramm 96 zeigt den Verlauf der schleifenspezifischen Wahrscheinlichkeitswerte W_{·s·} für alle möglichen Schleifen. Der Strom in der fehlerbehafteten Phase steigt (Stelle 93 in Diagramm 91). Dagegen bricht die Spannung der fehlerbehafteten Phase ein (Stelle 94 in Diagramm 92). Unter Anwendung der verschiedenen Schutzkriterien (z.B. Stromhöhekriterium, Spannungshöhekriterium, Delta-Stromhöhekriterium, Delta-Spannungshöhekriterium, Impedanzkriterium etc.) können schutzkriterienspezifische Wahrscheinlichkeitswerte für die einzelnen möglichen Schleifen bestimmt werden, aus denen wiederum ein jeweiliger schleifenspezifischer Wahrscheinlichkeitswert ermittelt wird. Der Algorithmus zur Erkennung der Fehlerart "fehlerbehaftete Schleife" reagiert schnell und ermittelt unter Berücksichtigung aller schutzkriterienspezifischen Wahrscheinlichkeitswerte in kurzer Zeit die fehlerbehaftete Schleife L1E (Stelle 95 in Diagramm 96), die einen schleifenspezifischen Wahrscheinlichkeitswert von über 85% aufweist. Die anderen Schleifen liegen meist unter 10%.

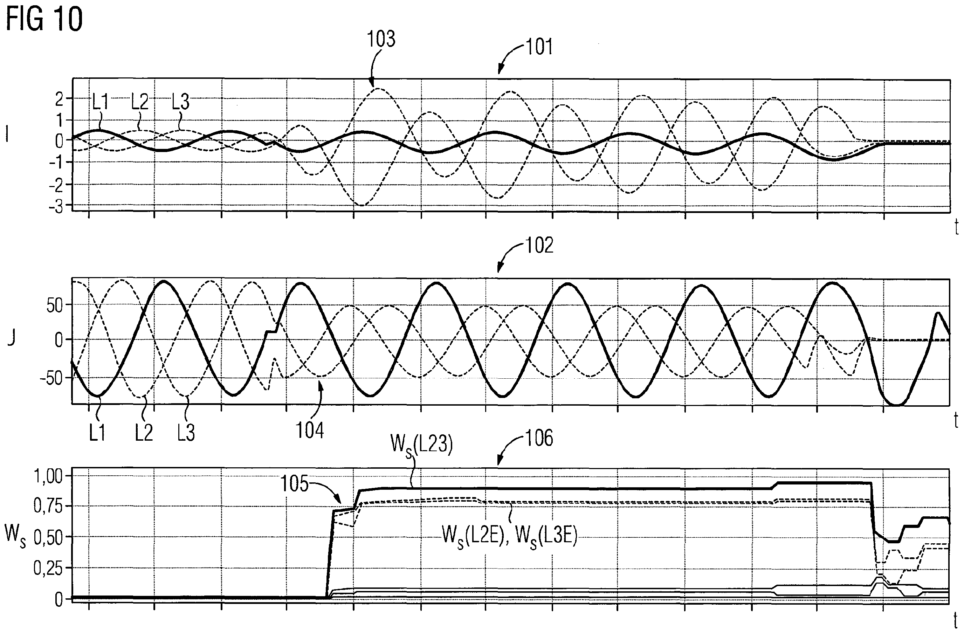

In Figur 10 sind typische zeitliche Verläufe der Ströme (Diagramm 101) und Spannungen (Diagramm 102) während eines zweipoligen Fehlers mit Erdbeteiligung (L23 mit Erdbeteiligung) dargestellt. Diagramm 106 zeigt den Verlauf der schleifenspezifischen Wahrscheinlichkeitswerte W_{·s·} für alle möglichen Schleifen. Beim Fehlereintritt steigt der Strom in den betroffenen Phasen (Stelle 103 in Diagramm 101), während die Spannung der betroffenen Phasen absinkt (Stelle 104 in Diagramm 102). Unter Anwendung der verschiedenen Schutzkriterien können schutzkriterienspezifische Wahrscheinlichkeitswerte für die einzelnen möglichen Schleifen bestimmt werden, aus denen wiederum ein jeweiliger schleifenspezifischer Wahrscheinlichkeitswert ermittelt wird. Auch in diesem Fall reagiert der Algorithmus zur Erkennung der Fehlerart "fehlerbehaftete Schleife" schnell und sicher. Es werden drei Schleifen (L23, L2E, L3E) mit schleifenspezifischen Wahrscheinlichkeitswerten über 75% Qualität ermittelt (Stelle 105 in Diagramm 106), was bei dieser Fehlerart die richtige Reaktion ist.

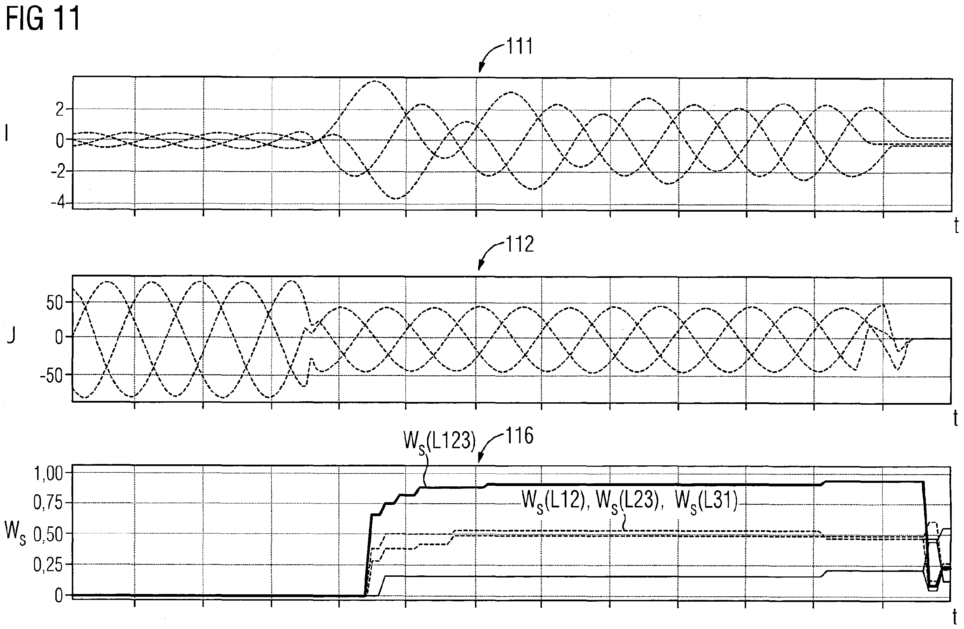

In Figur 11 sind typische zeitliche Verläufe der Ströme (Diagramm 111) und Spannungen (Diagramm 112) während eines dreipoligen Fehlers (L123) dargestellt. Diagramm 116 zeigt den Verlauf der schleifenspezifischen Wahrscheinlichkeitswerte W_{·s·} für alle möglichen Schleifen. In diesem Fall wird für die dreipolige Schleife L123 ein hoher schleifenspezifischer Wahrscheinlichkeitswert W_{·s·}(L123) berechnet. Da es sich um einen dreipoligen Fehler handelt, liegen auch die schleifenspezifischen Wahrscheinlichkeitswerte der zweipoligen Schleifen W_{·s·}(L12), W_{·s·}(L23), W_{·s·}(L31) relativ hoch. Die einpoligen Schleifen werden dagegen niedriger bewertet.

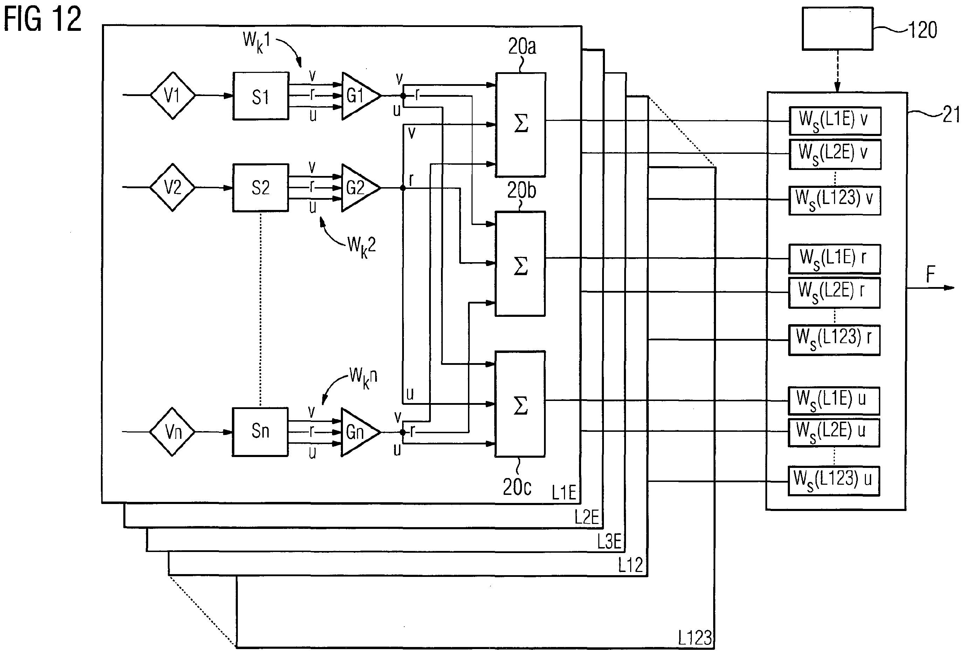

Das in Figur 2 gezeigte Ablaufblockschaltbild zeigt generell die Vorgehensweise bei der Erzeugung eines eine Fehlerart angebenden Fehlersignals. Für die Fehlerart "Fehlerrichtung" muss jedoch die Besonderheit berücksichtigt werden, dass das jeweilige Schutzkriterium insgesamt drei Ergebnisse liefern kann (Wahrscheinlichkeit für vorwärts, rückwärts, ungerichtet), während bei der Fehlerart "fehlerbehaftete Schleife" jeweils nur ein Ergebnis (Wahrscheinlichkeit für Fehler in der betreffenden Schleife) bestimmt wird. Daher soll unter Hinzunahme von Figur 12, die den Sonderfall von Figur 2 für die Fehlerart "Fehlerrichtung" zeigt, die Erzeugung eines die Fehlerrichtung eines Fehlers angebenden Fehlersignals erläutert werden. Die zu Figur 2 allgemein gemachten Ausführungen gelten jedoch auch für die Fehlerart "Fehlerrichtung", daher werden nachfolgend bei der Beschreibung von Figur 12 im Wesentlichen die Besonderheiten der Ermittlung dieser Fehlerart aufgezeigt.

Figur 12 zeigt beispielhaft in Form eines an die Darstellung von Figur 2 angelehnten Ablaufblockschaltbildes eine von der Auswerteinrichtung 14 (vgl. Figur 1) ausgeführte Funktion zur Ermittlung der Fehlerart "Fehlerrichtung" eines Fehlers und zur Erzeugung eines die ermittelte Fehlerart angebenden Fehlersignals F. Die Erkennung der Fehlerart wird für alle möglichen Schleifen, in denen ein Fehler auftreten kann, also L1E, L2E, L3E, L12, L23, L31, L123, durchgeführt. Nachfolgende Erläuterungen beziehen sich zunächst auf die mögliche Schleife L1E.

Zur Ermittlung der Fehlerart "Fehlerrichtung" eines Fehlers werden auch gemäß dem in Figur 12 gezeigten Ablaufblockschaltbild mehrere unterschiedliche Schutzkriterien S1, S2, ... Sn parallel zueinander ausgewertet. Jedes Schutzkriterium ist für sich selbständig dazu geeignet, eine Aussage über die Fehlerart "Fehlerrichtung" eines vorliegenden Fehlers zu treffen, verwendet dazu aber unterschiedliche Eingangsgrößen (Messwerte bzw. abgeleitete Werte) und/oder Algorithmen. Die Ergebnisse der Auswertungen der unterschiedlichen Schutzkriterien Sl...Sn werden in Form von schutzkriterienspezifischen Wahrscheinlichkeitswerten W.ₖ.1...W.ₖ.n ausgegeben, die jeweils angeben, mit welcher Wahrscheinlichkeit gemäß dem ausgewerteten Schutzkriterium die Fehlerart vorliegt. Hierbei ist die Besonderheit zu berücksichtigen, dass jedes Schutzkriterium Sl...Sn aufgrund der möglichen Fehlerrichtungen
v: "vorwärts",
r: "rückwärts",
u: "ungerichtet" (ungerichtet bedeutet, dass die Fehlerrichtung nicht eindeutig bestimmbar ist)

jeweils bis zu drei unterschiedliche Ergebnisse ausgeben kann. Hierbei kann z.B. vorgesehen sein, dass die Schutzkriterien Sl...Sn sich für eines der Ergebnisse entscheiden und somit nur einen einzigen schutzkriterienspezifischen Wahrscheinlichkeitswert abgeben. Beispielsweise könnte das Schutzkriterium S1 in diesem Fall einen einzigen schutzkriterienspezifischen Wahrscheinlichkeitswert W_{·k·}1_v für die Vorwärtsrichtung abgeben, während keine schutzkriterienspezifischen Wahrscheinlichkeitswerte W_{·k·}1_r und W_{·k·}1_u für die Rückwärtsrichtung bzw. den ungerichteten Fall abgegeben werden.

Alternativ kann jedoch auch vorgesehen sein, dass die Schutzkriterien für jeden der drei Fälle einen schutzkriterienspezifischen Wahrscheinlichkeitswert abgeben. Die Summe dieser schutzkriterienspezifischen Wahrscheinlichkeitswerte sollte in diesem Fall vorzugsweise 1 betragen, wobei einer oder zwei der Werte auch 0 sein können. Durch die Angabe von bis drei schutzkriterienspezifischen Wahrscheinlichkeitswerten können auch Grenzfälle, in denen nicht klar zwischen einzelnen Richtungen bzw. einer Richtung und einem ungerichteten Fall entschieden werden kann, transparent angegeben werden und in die Bildung des Fehlersignals eingehen.

Somit gibt jedes Schutzkriterium Sl...Sn bis zu drei schutzkriterienspezifische Wahrscheinlichkeitswerte W_{·k·}1_v...W_{·k·}n_v, W_{·k·_}r...W_{·k·}n_r und W_{·k·}_u...W_{·k·}n_u ab. Daraufhin findet wieder eine Multiplikation der schutzkriterienspezifischen Wahrscheinlichkeitswerte mit geeigneten Gewichtungsfaktoren Gl...Gn statt, um eine Priorisierung der einzelnen Schutzkriterien Sl...Sn vorzunehmen. Für Details zu den Gewichtungsfaktoren Gl...Gn wird auf die Ausführungen zu Figur 2 verwiesen.

Die gewichteten schutzkriterienspezifischen Wahrscheinlichkeitswerte W_{·k·}1_v...W_{·k·}n_v, W_{·k·}_r...W_{·k·}n_r und W_{·k·}_u...W_{·k·}n_u werden daraufhin je einem Summationsblock 20a-c für die jeweilige Fehlerrichtung zugeführt, wo jeweils die Summe der einzelnen schutzkriterienspezifischen Wahrscheinlichkeitswerte W_{·k·}1_v...W_{·k·}n_v, W_{·k·}_r...W_{·k·}n_r und W_{·k·}_u...W_{·k·}n_u für die jeweilige Fehlerrichtung unter Bildung je eines Gesamt-Ergebnisses in Form je eines schleifenspezifischen Wahrscheinlichkeitswertes für die jeweilige Fehlerrichtung W_{·s·}(L1E)_v, W_{·s·}(L1E)_r, W_{·s·}(L1E)_u bestimmt wird. Der jeweilige schleifenspezifische Wahrscheinlichkeitswert gibt an, mit welcher Wahrscheinlichkeit für die betrachtete Schleife die jeweilige Fehlerrichtung vorliegt.

Die beispielhaft für die Schleife L1E erläuterte Vorgehensweise findet wie bereits zu Figur 2 beschrieben auch für alle anderen möglichen Schleifen, in denen ein Fehler auftreten kann, statt. Für jede Schleife wird in der beschriebenen Weise je ein schleifenspezifischer Wahrscheinlichkeitswert W_{·s·}(L1E)_v...W_{·s·}(L123)_v, W_{·s·}(L1E)_v...W_{·s·}(L123)_r, W_{·s·}(L1E)_v...W_{·s·}(L123)_u ermittelt und ausgegeben. In dem nachfolgenden Kombinationsblock 21 werden die jeweiligen schleifenspezifischen Wahrscheinlichkeitswerte gesammelt und ausgewertet. Unter Berücksichtigung aller schleifenspezifischen Wahrscheinlichkeitswerte W._{s.}(L1E)_v...W_{·s·}(L123)_v, W_{·s·}(L1E)_v...W_{·s·}(L123)_r, W._{s.}(L1E)_v...W_{·s·}(L123)_u wird schließlich das die Fehlerrichtung angebende Fehlersignal F gebildet. Das erzeugte Fehlersignal F gibt die unter Berücksichtigung aller schleifenspezifischen Wahrscheinlichkeitswerte (und damit auch unter Berücksichtigung aller schutzkriterienspezifischen Wahrscheinlichkeitswerte aller Schleifen) ermittelte Fehlerart an, damit unter Berücksichtigung dieses Fehlersignals ein etwaiges Auslösesignal A für einen Schalter erzeugt werden kann.

Bei der Fehlerart "Fehlerrichtung" kann die Bildung des Fehlersignals entweder allein anhand der für die Fehlerart "Fehlerrichtung" vorliegenden schleifenspezifischen Wahrscheinlichkeitswerte getroffen werden. Dabei kann beispielsweise ein schleifenspezifischer Wahrscheinlichkeitswert mit einem signifikant hohen Wert, der im Vergleich zu den anderen schleifenspezifischen Wahrscheinlichkeitswerten eindeutig für eine bestimmte Schleife eine bestimmte Fehlerrichtung anzeigt, zur Bildung des Fehlersignals ausgewählt werden. Das Fehlersignal für die Fehlerart "Fehlerrichtung" kann aber auch in Kombination mit einem anderen Algorithmus 120, der die Fehlerart "fehlerbehaftete Schleife" ermittelt, arbeiten. Von diesem Algorithmus erhält der Kombinationsblock 21 eine Information über die fehlerbehaftete Schleife und berücksichtigt diese zusätzlich bei der Bildung des Fehlersignals in der Weise, dass für die mittels der Information von dem Algorithmus 120 angegebene fehlerbehafteten Schleife die von dem zu der fraglichen Schleife gehörenden schleifenspezifischen Wahrscheinlichkeitswerte für die Fehlerart "Fehlerrichtung" miteinander verglichen werden. Die Fehlerrichtung, die von dem schleifenspezifischen Wahrscheinlichkeitswert mit dem höchsten Wert angegeben wird, wird als tatsächliche Fehlerrichtung für die fragliche Schleife ausgewählt und zur Bildung des Fehlersignals F verwendet. Der Algorithmus 120 zur Ermittlung der Fehlerart "fehlerbehaftete Schleife" kann beispielsweise wie zuvor zu Figur 2 beschrieben funktionieren; er kann aber auch in anderer Weise implementiert sein.

Um gegen Fehlauslösungen ausreichende Sicherheit zu bieten, kann wieder vorgesehen sein, dass das Fehlersignal F nur dann erzeugt wird, wenn der größte schleifenspezifische Wahrscheinlichkeitswert einen Fehlererkennungs-Schwellenwert überschreitet. Dieser Schwellenwert kann entweder fest vorgegeben sein oder an die jeweiligen schleifenspezifische Wahrscheinlichkeitswerte angepasst werden.

Sofern für die Anwendung eines bestimmten Schutzkriteriums Sl...Sn die notwendigen Messwerte und/oder abgeleiteten Werte nicht vorhanden sind, ist es auch bei der Ermittlung der Fehlerart "Fehlerrichtung" möglich, das fragliche Schutzkriterium temporär aus der Auswertung herauszunehmen. Die diesbezügliche Prüfung findet wieder in den Schutzkriterien Sl...Sn vorgelagerten Vorbedingungsprüfungs-Blöcken Vl...Vn statt. Sofern in einem solchen Vorbedingungsprüfungs-Block V1...Vn festgestellt wird, dass die notwendigen Messwerte und/oder abgeleiteten Werte zur Ausführung des Schutzkriteriums nicht vorliegen, wird dieses vorübergehend deaktiviert, bis die notwendigen Messwerte und/oder abgeleiteten Werte wieder vorliegen. Außerdem können wieder die Gewichtungsfaktoren Gl...Gn der tatsächlich verwendeten Schutzkriterien angepasst werden (siehe die Ausführungen zu Figur 2).

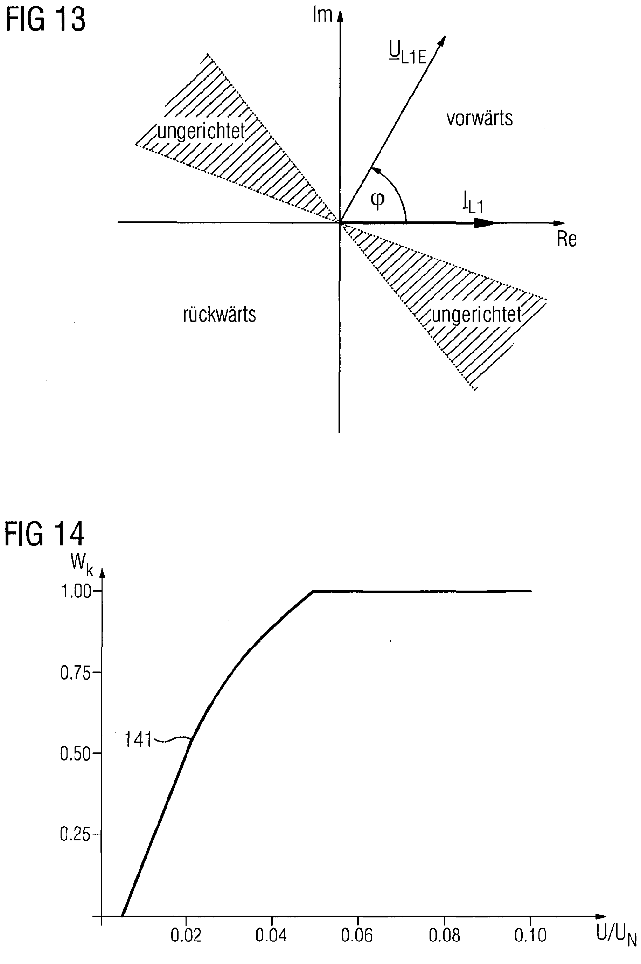

Beispielsweise kann das erste Schutzkriterium S1 für die Ermittlung der Fehlerrichtung die kurzschlussgetreue aktuelle Spannung verwenden. Dieses Schutzkriterium bestimmt das Verhältnis zwischen dem aktuellen Spannungszeiger und dem aktuellen Stromzeiger (siehe Figur 13). Der berechnete Winkel ϕ zwischen den beiden Zeigern gibt Aufschluss über die Fehlerrichtung; vorliegend ist eine Vorwärtsrichtung erkennbar. In Figur 14 ist beispielhaft ein Diagramm mit einer Kennlinie 141 dargestellt. Hier ist gezeigt, wie das erste Schutzkriterium S1 aus der Höhe der Spannung U/U_{·N·} die Höhe eines schutzkriterienspezifischen Wahrscheinlichkeitswertes W_{·k·}1 für die jeweilige aus dem Winkel (vgl. Diagramm 13) erkannte Fehlerrichtung ermittelt. Man erkennt, dass mit steigender Spannung U/U_{·N·} die Wahrscheinlichkeit, mit der die aus dem Winkel abgeleitete Fehlerrichtung für die geprüfte Schleife vorliegt, ebenfalls ansteigt. Der entsprechend der Kennlinie 141 in dem Diagramm ermittelte schutzkriterienspezifische Wahrscheinlichkeitswert W_{·k·}1 für die jeweilige Fehlerrichtung wird vom Block S1 (vgl. Figur 12) abgegeben, mit dem Gewichtungsfaktor G1 multipliziert und den Summationsblöcken 20a-c zugeführt.

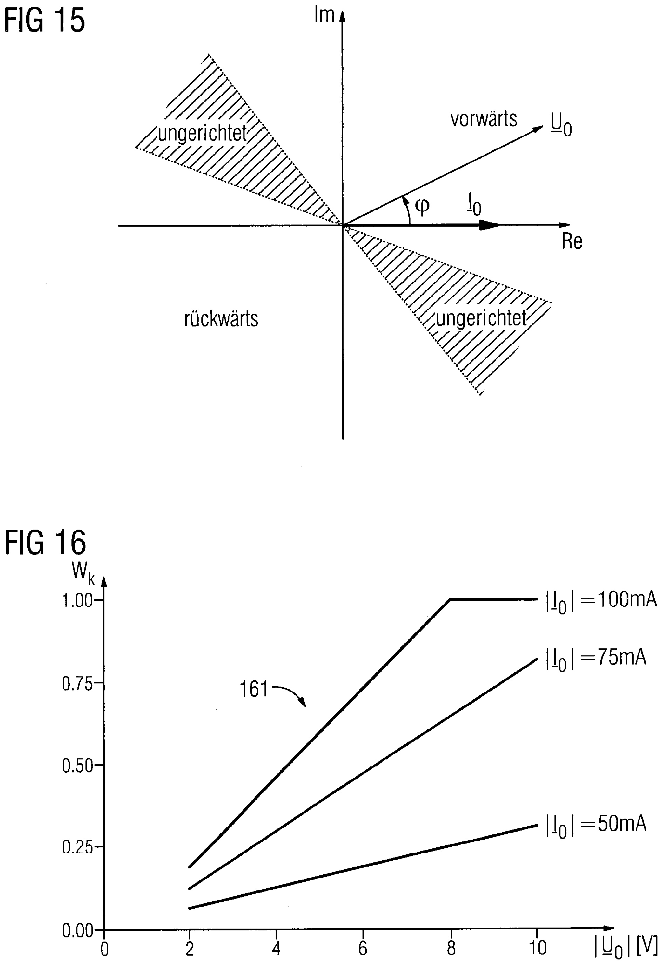

Als zweites Schutzkriterium S2 zur Ermittlung der Fehlerart "Fehlerrichtung" kann beispielsweise ein Symmetrische Komponenten-Kriterium verwendet werden. Die Richtungsbestimmung basiert auf den symmetrischen Komponenten. Bei der Richtungsbestimmung mit Nullsystemgrößen wird der Winkel ϕ zwischen den Spannungs- und Stromzeigern des Nullsystems bestimmt (siehe Figur 15). Der berechnete Winkel gibt Aufschluss über die Fehlerrichtung; vorliegend ergibt sich eine Vorwärtsrichtung. Das Verfahren funktioniert nur bei Fehlern mit Erdbeteiligung. Figur 16 zeigt beispielhaft ein Diagramm mit einem Kennlinienfeld 161 für verschiedene Nullsystemströme, das in Abhängigkeit von der Nullsystemspannung eine Ermittlung des zugehörigen schutzkriterienspezifischen Wahrscheinlichkeitswertes W_{·k·} für die anhand des Winkels erkannte Fehlerrichtung ermöglicht. Der entsprechend des Kennlinienfeldes 161 in dem Diagramm ermittelte schutzkriterienspezifische Wahrscheinlichkeitswert W_{·k·}1 für die entsprechend des Winkels (siehe Figur 15) erkannte jeweilige Fehlerrichtung wird vom Block S2 abgegeben, mit dem Gewichtungsfaktor G2 multipliziert und den Summationsblöcken 20a-c zugeführt.

Andere mögliche Schutzkriterien können z.B. eine kurzschlussgetreue gespeicherte Spannung, eine kurzschlussfremde aktuelle Spannung oder eine kurzschlussfremde gespeicherte Spannung verwenden; außerdem kann ein Deltagrößenkriterium verwendet werden. Auch die Verwendung anderer geeigneter Schutzkriterien ist selbstverständlich möglich, so dass die Schutzeinrichtung durch Auswahl der passenden Schutzkriterien immer an die durch die Topologie und Konfiguration des überwachten Energieversorgungsnetzes vorgegebenen Bedingungen angepasst werden kann.

Die gewichteten schutzkriterienspezifischen Wahrscheinlichkeitswerte für die einzelnen Fehlerrichtungen werden wie oben bereits erläutert den Summationsblöcken 20a-c zugeführt, die durch Addition den jeweiligen schleifenspezifischen Wahrscheinlichkeitswert für die jeweilige Fehlerrichtung bilden.

Das erzeugte Fehlersignal F gibt die unter Berücksichtigung aller schleifenspezifischen Wahrscheinlichkeitswerte (und damit auch unter Berücksichtigung aller schutzkriterienspezifischen Wahrscheinlichkeitswerte aller Schleifen) ermittelte Fehlerart "Fehlerrichtung" an, damit unter Berücksichtigung dieses Fehlersignals ein etwaiges Auslösesignal A für einen Schalter erzeugt werden kann.

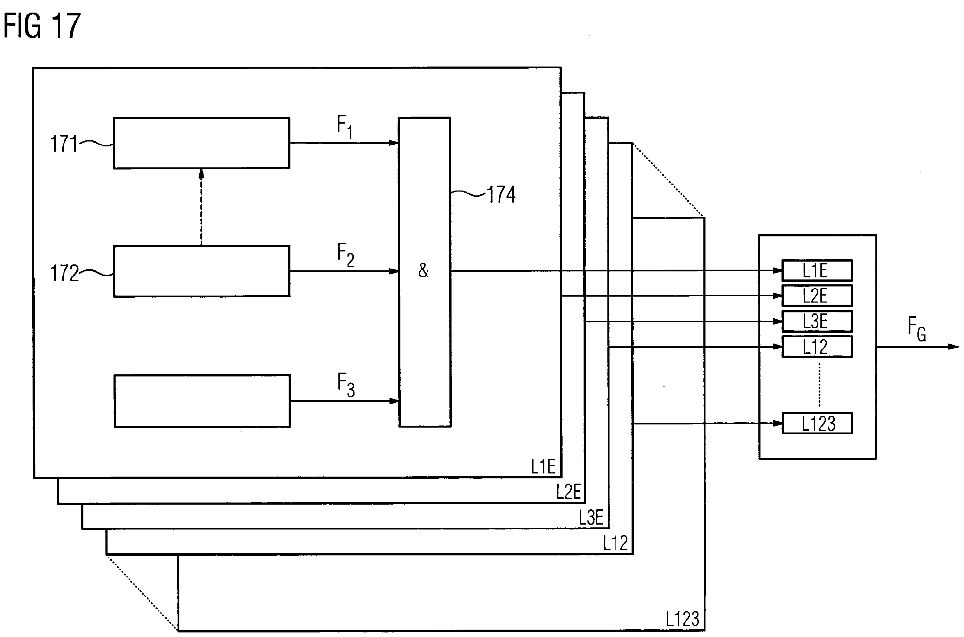

Die jeweils die Fehlerarten "fehlerbehaftete Schleife" und "Fehlerrichtung" angebenden Fehlersignale können jeweils für sich als Fehlersignal zur Erzeugung eines etwaigen Auslösesignals für einen Leistungsschalter verwendet werden. Besonders vorteilhaft kann jedoch auch ein Gesamt-Fehlersignal F_{·G·} erzeugt werden, das durch Kombination der Fehlersignale für die einzelnen Fehlerarten ermittelt wird. Dies ist in Figur 17 angedeutet. Figur 17 zeigt ein schematisches Ablaufblockschaltbild, in dem mittels eines ersten Algorithmus 171 ein erstes Fehlersignal F_{·1·} erzeugt wird, das eine Fehlerrichtung als Fehlerart angibt. Der erste Algorithmus 171 kann beispielsweise entsprechend den zu Figuren 2 und 12 gemachten Ausführungen arbeiten. Mittels eines zweiten Algorithmus 172 wird ein zweites Fehlersignal F_{·2·} erzeugt, das eine fehlerbehaftete Schleife als Fehlerart angibt. Der zweite Algorithmus 172 kann beispielsweise entsprechend den zu Figur 2 gemachten Ausführungen arbeiten. Wie durch einen gestrichelten Pfeil angedeutet, kann der zweite Algorithmus 172 auch eine Information über eine identifizierte Fehlerschleife an den ersten Algorithmus übergeben; diese Information kann dann wie zu Figur 12 beschrieben von dem ersten Algorithmus 171 zur Erzeugung des ersten Fehlersignals F_{·1·} verwendet werden. Unter Berücksichtigung der beiden Fehlersignale F_{·1·} und F_{·2·} kann ein Gesamt-Fehlersignal F_{·G·} erzeugt werden, das die fehlerbehaftete Schleife und die Fehlerrichtung in der fraglichen Schleife angibt. Dazu können beispielsweise bei Fehlersignale F_{·1·} und F_{·2·} mittels eines UND-Gliedes 174 miteinander verbunden werden.

Außerdem kann vorgesehen sein, dass mittels eines dritten Algorithmus 173 ein Fehlerzonensignal F_{·3·} erzeugt wird, wenn ein Fehler innerhalb der von der Schutzeinrichtung überwachten Schutzzone vorliegt. Bei dem dritten Algorithmus kann es sich z.B. um einen Distanzschutzalgorithmus handeln, der unter Verwendung von Impedanzzeigern erkennt, ob ein Fehler in einer von der Schutzeinrichtung überwachten Schutzzone vorliegt. Der dritte Algorithmus kann jedoch auch jeder beliebige andere Schutzalgorithmus sein, z.B. ein Überstrom-Zeit-Schutzalgorithmus. Das Gesamt-Fehlersignal F_{·G·} kann dann auch unter zusätzlicher Berücksichtigung des Fehlerzonensignals F_{·3·} erzeugt werden; hierzu können beispielsweise alle Fehlersignale F_{·1·}-F_{·3·} mittels des UND-Gliedes 174 miteinander kombiniert werden.

Die beschriebene Vorgehensweise findet für jede Schleife statt, das Gesamt-Fehlersignal F_{·G·} zeigt schließlich jedoch nur die tatsächlich von dem Fehler in der Schutzzone betroffene Schleife und dessen Fehlerrichtung an.

Unter Verwendung des Gesamt-Fehlersignals F_{·G·} kann ein Auslösesignal zum Ansteuern eines Leistungsschalters zum Abschalten des Fehlers erzeugt werden.

Voranstehend wurde ein Algorithmus beschrieben, mit dem ein eine Fehlerart angebendes Fehlersignal besonders vorteilhaft erzeugt werden kann. Ein besonderer Vorteil besteht darin, dass zur Entscheidung über die Fehlerart mehrere Schutzkriterien parallel ausgewertet werden und die Ergebnisse aller Auswertungen in die Erzeugung des Fehlersignals einfließen. Der beschriebene Algorithmus kann sehr flexibel auf neue Netzbedingungen und Netzkonstellationen angepasst werden. Die Schutzkriterien, die bei einem ersten Energieversorgungsnetz eine große Rolle spielen, müssen nämlich bei einer Netzbeschaffenheit eines anderen Energieversorgungsnetzes nicht die gleiche Bedeutung besitzen. Durch Auswahl geeigneter Schutzkriterien kann der Algorithmus sehr flexibel an das jeweilige Energieversorgungsnetz angepasst werden. Außerdem kann eine Verschiebung der Gewichtung der einzelnen Schutzkriterien abhängig von der Netzauslegung stattfinden. Im Zuge der verstärkt stattfindenden bidirektionalen Energieübertragung in Energieversorgungsnetzen werden sich die Netzkonfiguration sowie die Kurzschlussleitung des Netzes häufiger ändern. Der beschriebene Algorithmus stellt eine zukunftsorientierte Smart Grid Applikation dar. Er gewährleistet eine verbesserte Stabilität bei der Schleifenauswahl und Richtungserkennung, was die Grundlage für das korrekte Funktionieren eines beliebigen Schutzalgorithmus, z.B. eines Distanzschutzalgorithmus, ist.

## Patentansprüche

1. Verfahren zum Erzeugen eines eine Fehlerart eines Fehlers in einem mehrphasigen elektrischen Energieversorgungsnetz angebenden Fehlersignals, bei dem
- an mindestens einer Messstelle (11) in dem Energieversorgungsnetz Messwerte erfasst werden, die einen aktuellen Betriebszustand des Energieversorgungsnetzes beschreiben;
- die Messwerte an eine Schutzeinrichtung (12) übermittelt werden;
- mittels einer Auswerteinrichtung (14) der Schutzeinrichtung (12) unter Verwendung der Messwerte jede mögliche Schleife des Energieversorgungsnetzes, die von einem Fehler betroffen sein kann, hinsichtlich der Erkennung der Fehlerart eines Fehlers ausgewertet wird; und
- bei Vorliegen eines Fehlers das Fehlersignal erzeugt wird, wobei- für jede mögliche Schleife die Messwerte und/oder aus den Messwerten abgeleitete Werte unter Verwendung von zumindest zwei unterschiedlichen Schutzkriterien ausgewertet werden, wobei jedes der Schutzkriterien dazu geeignet ist, auf eine Fehlerart eines vorliegenden Fehlers in der jeweils ausgewerteten Schleife hinzuweisen; und
- das Fehlersignal unter Berücksichtigung aller vorliegenden Ergebnisse der Auswertung der Schutzkriterien erzeugt wird;
**dadurch gekennzeichnet, dass**
- das Ergebnis der Auswertung des jeweiligen Schutzkriteriums unter Bildung eines gewichteten Ergebnisses mit einem Gewichtungsfaktor multipliziert wird;
- für jede mögliche Schleife alle gewichteten Ergebnisse unter Bildung eines Gesamtergebnisses verknüpft werden; das jeweilige Ergebnis der Auswertung des jeweiligen Schutzkriteriums in Form eines schutzkriterienspezifischen Wahrscheinlichkeitswerts gebildet wird, der angibt, mit welcher Wahrscheinlichkeit gemäß dem ausgewerteten Schutzkriterium ein Fehler mit der Fehlerart vorliegt; und
- das jeweilige Gesamtergebnis in Form eines schleifenspezifischen Wahrscheinlichkeitswerts gebildet wird, der angibt, mit welcher Wahrscheinlichkeit in der betrachteten Schleife ein Fehler mit der Fehlerart vorliegt.

2. Verfahren nach Anspruch 1,
**dadurch gekennzeichnet, dass**
- die Schutzkriterien parallel zueinander ausgewertet werden.

3. Verfahren nach Anspruch 1 oder 2,
**dadurch gekennzeichnet, dass**
- das Fehlersignal unter Berücksichtigung der Gesamtergebnisse aller ausgewerteten Schleifen erzeugt wird.

4. Verfahren nach einem der vorangehenden Ansprüche,
**dadurch gekennzeichnet, dass**
- für jede mögliche Schleife die Gewichtungsfaktoren für alle ausgewerteten Schutzkriterien so gewählt werden, dass ihre Summe 1 ergibt.

5. Verfahren nach einem der vorangehenden Ansprüche,
**dadurch gekennzeichnet, dass**
- die Höhe der jeweiligen Gewichtungsfaktoren in Abhängigkeit von der jeweiligen Konfiguration des Energieversorgungsnetzes gewählt wird.

6. Verfahren nach einem der vorangehenden Ansprüche,
**dadurch gekennzeichnet, dass**
- das Fehlersignal nur dann erzeugt wird, wenn das Gesamtergebnis zumindest einer möglichen Schleife einen Fehlererkennungs-Schwellenwert überschreitet.

7. Verfahren nach einem der vorangehenden Ansprüche,
**dadurch gekennzeichnet, dass**
- ein jeweiliges Schutzkriterium nur dann ausgewertet wird, wenn alle zu seiner Auswertung erforderlichen Messwerte und/oder abgeleiteten Werte vorliegen.

8. Verfahren nach einem der vorangehenden Ansprüche,
**dadurch gekennzeichnet, dass**
- ein jeweiliges Schutzkriterium nur dann ausgewertet wird, wenn alle zu seiner Auswertung erforderlichen Messwerte und/oder abgeleiteten Werte vorliegen; und
- das Gesamtergebnis nur unter Verwendung von gewichteten Ergebnissen solcher Schutzkriterien gebildet wird, die ausgewertet worden sind.

9. Verfahren nach einem der vorangehenden Ansprüche,
**dadurch gekennzeichnet, dass**
- das Fehlersignal als Fehlerart die Richtung eines Fehlers angibt.

10. Verfahren nach einem der Ansprüche 1 bis 8,
**dadurch gekennzeichnet, dass**
- das Fehlersignal als Fehlerart die fehlerbehaftete Schleife angibt.

11. Verfahren nach einem der Ansprüche 1 bis 9,
**dadurch gekennzeichnet, dass**
- ein erstes Fehlersignal erzeugt wird, das als Fehlerart die Richtung eines Fehlers angibt;
- ein zweites Fehlersignal erzeugt wird, das als Fehlerart die fehlerbehaftete Schleife angibt; und
- ein Gesamt-Fehlersignal unter Berücksichtigung des ersten und des zweiten Fehlersignals erzeugt wird.

12. Verfahren nach Anspruch 11,
**dadurch gekennzeichnet, dass**
- mittels der Auswerteinrichtung (14) auch geprüft wird, ob ein Fehler in einer unmittelbar von der Schutzeinrichtung (12) überwachten Schutzzone des Energieversorgungsnetzes vorliegt und ein Fehlerzonensignal erzeugt wird, wenn ein Fehler in der Schutzzone vorliegt; und
- das Gesamt-Fehlersignal auch unter Berücksichtigung des Fehlerzonensignals erzeugt wird.

13. Schutzeinrichtung (12) zum Erzeugen eines eine Fehlerart eines Fehlers in einem mehrphasigen elektrischen Energieversorgungsnetz angebenden Fehlersignals, mit
- einer Messwerterfassungseinrichtung (13) zum Erfassen von an mindestens einer Messstelle in dem Energieversorgungsnetz aufgenommener Messwerte, die einen aktuellen Betriebszustand des Energieversorgungsnetzes beschreiben; und
- einer Auswerteinrichtung (14), die dazu eingerichtet ist, unter Verwendung der Messwerte jede mögliche Schleife des Energieversorgungsnetzes, die von einem Fehler betroffen sein kann, hinsichtlich der Erkennung der Fehlerart eines Fehlers auszuwerten und bei Vorliegen eines Fehlers das Fehlersignal zu erzeugen;
**dadurch gekennzeichnet, dass**
- die Auswerteinrichtung (14) dazu eingerichtet ist, ein Verfahren nach einem der Ansprüche 1 bis 12 auszuführen.

## Claims

1. Method for generating an error signal indicating an error type of an error in a multi-phase electrical energy supply network, wherein
- measured values are detected at at least one measurement point (11) in the energy supply network which describe a current operating state of the energy supply network;
- the measured values are transmitted to a protection device (12) ;
- each potential loop of the energy supply network that can be affected by an error is evaluated with respect to the recognition of the error type of an error, by means of an evaluation device (14) of the protection device (12), using the measured values; and
- if an error is present, the error signal is generated,
wherein
- for each potential loop, the measured values and/or values derived from the measured values are evaluated by the application of at least two different protection criteria, wherein each of the protection criteria is appropriate for the identification of an error type of an error present in the respective loop thus evaluated; and
- the error signal is generated in consideration of all available results for the evaluation of the protection criteria; **characterized in that**
- the result of the evaluation of the respective protection criterion is multiplied by a weighting factor to form a weighted result;
- for each potential loop, all the weighted results are combined to form an overall result; the respective result of the evaluation of the respective protection criterion is constituted in the form of a protection criteria-specific probability value, which indicates the probability, according to the protection criterion evaluated, of the presence of an error of the relevant error type; and
- the respective overall result is constituted in the form of a loop-specific probability value, which indicates the probability of the presence of an error of the relevant error type in the loop considered.

2. Method according to Claim 1,
**characterized in that**
- the protection criteria are evaluated in a mutually parallel manner.

3. Method according to Claim 1 or 2,
**characterized in that**
- the error signal is generated in consideration of the overall results for all the loops evaluated.

4. Method according to one of the preceding claims, **characterized in that**
- for each potential loop, the weighting factors for all the protection criteria evaluated are selected such that the sum thereof is equal to 1.

5. Method according to one of the preceding claims, **characterized in that**
- the magnitude of the respective weighting factors is selected in accordance with the respective configuration of the energy supply network.

6. Method according to one of the preceding claims, **characterized in that**
- the error signal is only generated if the overall result for at least one potential loop exceeds an error detection threshold value.

7. Method according to one of the preceding claims, **characterized in that**
- a respective protection criterion is only evaluated if all the measured values and/or derived values required for the evaluation thereof are available.

8. Method according to one of the preceding claims, **characterized in that**
- a respective protection criterion is only evaluated if all the measured values and/or derived values required for the evaluation thereof are available; and
- the overall result is only constituted by the application of the weighted results of those protection criteria which have been evaluated.

9. Method according to one of the preceding claims, **characterized in that**
- as an error type, the error signal indicates the direction of an error.

10. Method according to one of Claims 1 to 8,
**characterized in that**
- as an error type, the error signal indicates the defective loop.

11. Method according to one of Claims 1 to 9,
**characterized in that**
- a first error signal is generated which, as an error type, indicates the direction of an error;
- a second error signal is generated which, as an error type, indicates the defective loop; and
- an overall error signal is generated in consideration of the first and second error signals.

12. Method according to Claim 11,
**characterized in that**
- using the evaluation device (14), it is also verified whether an error is present in a protection zone of the energy supply network which is directly monitored by the protection device (12), and an error zone signal is generated if an error is present in the protection zone; and
- the overall error signal is also generated in consideration of the error zone signal.

13. Protection device (12) for generating an error signal indicating an error type of an error in a multi-phase electrical energy supply network, having
- a measured value detection device (13) for the detection of measured values recorded at at least one measurement point in the energy supply network, which describe a current operating state of the energy supply network; and
- an evaluation device (14) which is designed, by the use of measured values, to evaluate each potential loop of the energy supply network that can be affected by an error, with respect to the detection of the error type of an error and, in the event of the presence of an error, to generate the error signal;
**characterized in that**
- the evaluation device (14) is designed for the execution of a method according to one of Claims 1 to 12.

## Revendications

1. Procédé de production d'un signal de défaut indiquant un type d'un défaut dans un réseau d'alimentation en énergie électrique polyphasée, dans lequel
- on relève en au moins un point (11) de mesure du réseau d'alimentation en énergie des valeurs de mesure, qui décrivent un état de fonctionnement en cours du réseau d'alimentation en énergie ;
- on transmet les valeurs de mesure à un dispositif (12) de protection ;
- au moyen d'un dispositif (14) d'exploitation du dispositif (12) de protection, on évalue en ce qui concerne la détection du type d'un défaut, en utilisant les valeurs de mesure, chaque boucle possible du réseau d'alimentation en énergie qui peut être concernée par un défaut ; et
- en présence d'un défaut, on produit le signal de défaut, dans lequel pour chaque boucle possible, on évalue les valeurs de mesure et/ou des valeurs qui s'en déduisent en utilisant au moins deux critères de protection différents, chacun des critères de protection étant propre à indiquer un type d'un défaut présent dans la boucle évaluée respectivement ; et
- on produit le signal de défaut en tenant compte de tous les résultats existants de l'exploitation des critères de protection ; **caractérisé en ce que**
- on multiplie par un facteur de pondération le résultat de l'exploitation du critère de protection respectif en formant un résultat pondéré ;
- pour chaque boucle possible, on combine tous les résultats pondérés en formant un résultat d'ensemble; on forme le résultat respectif de l'exploitation du critère de protection respectif sous la forme d'une valeur de probabilité spécifique au critère de protection, qui indique la probabilité avec laquelle il y a suivant le critère de protection exploité un défaut ayant le type de défaut ; et
- on forme le résultat d'ensemble respectif sous la forme d'une valeur de probabilité spécifique à une boucle, qui indique la probabilité avec laquelle il y a un défaut ayant le type de défaut dans la boucle considérée.

2. Procédé suivant la revendication 1,
**caractérisé en ce que**
- on évalue les critères de protection parallèlement entre eux.

3. Procédé suivant la revendication 1 ou 2,
**caractérisé en ce que**
- on produit le signal de défaut en tenant compte du résultat d'ensemble de toutes les boucles évaluées.

4. Procédé suivant l'une des revendications précédentes, **caractérisé en ce que**
- pour chaque boucle possible, on choisit les facteurs de pondération pour tous les critères de protection évalués de manière à ce que leur somme soit égale à 1.

5. Procédé suivant l'une des revendications précédentes, **caractérisé en ce que**
- on choisit le niveau des facteurs de pondération respectif en fonction de la configuration respective du réseau d'alimentation en énergie.

6. Procédé suivant l'une des revendications précédentes, **caractérisé en ce que**
on ne produit le signal de défaut que si le résultat d'ensemble d'au moins une boucle possible dépasse une valeur de seuil de détection de défaut.

7. Procédé suivant l'une des revendications précédentes, **caractérisé en ce que**
- on n'évalue un critère de protection respectif que si l'on a toutes les valeurs de mesure et/ou des valeurs qui s'en déduisent nécessaires à son évaluation.

8. Procédé suivant l'une des revendications précédentes, **caractérisé en ce que**
- on n'évalue un critère de protection respectif que si l'on a toutes les valeurs de mesure et/ou des valeurs qui s'en déduisent nécessaires à son évaluation ; et
- on forme le résultat d'ensemble seulement en utilisant des résultats pondérés des critères de protection de ce genre qui ont été évalués.

9. Procédé suivant l'une des revendications précédentes, **caractérisé en ce que**
- le signal de défaut indique comme type du défaut la direction d'un défaut.

10. Procédé suivant l'une des revendications 1 à 8,
**caractérisé en ce que**
- le signal de défaut indique comme type du défaut la boucle entachée du défaut.

11. Procédé suivant l'une des revendications 1 à 9,
**caractérisé en ce que**
- on produit un premier signal de défaut, qui indique comme type du défaut la direction d'un défaut ;
- on produit un deuxième signal de défaut, qui indique comme type du défaut la boucle entachée du défaut ; et
- on produit un signal de défaut d'ensemble en tenant compte du premier et du deuxième signal de défaut.

12. Procédé suivant la revendication 11,
**caractérisé en ce que**
- on contrôle aussi au moyen du dispositif (14) d'évaluation s'il y a un défaut dans une zone de protection, contrôlée directement par le dispositif (12) de protection, du réseau d'alimentation en énergie et on produit un signal de zone du défaut s'il y a un défaut dans la zone de protection ; et
- on produit un signal de défaut d'ensemble en tenant compte également du signal de zone du défaut.

13. Dispositif (12) de protection pour la production d'un signal de défaut indiquant un type d'un défaut dans un réseau d'alimentation en énergie électrique polyphasé, comprenant
- un dispositif (13) de détection de valeurs de mesure pour la détection des valeurs de mesure enregistrées en au moins un point de mesure dans le réseau d'alimentation et décrivant un état de fonctionnement en cours du réseau d'alimentation en énergie ; et
- un dispositif (14) d'exploitation qui est conçu pour, en utilisant les valeurs de mesure, évaluer chaque boucle possible du réseau d'alimentation en énergie qui peut être concernée par un défaut en ce qui concerne la détection du type d'un défaut et pour produire le signal de défaut en présence d'un défaut ; **caractérisé en ce que**
- le dispositif (14) d'évaluation est conçu pour effectuer un procédé suivant l'une des revendications 1 à 12.
